# EUROPEAN PATENT APPLICATION

(11) **EP 2 571 043 A1**
(43) Date of publication of application: **20.03.2013**
(21) Application number: 11780349.4
(22) Date of filing: 22.04.2011
(51) Int. Cl.: H01L 21/336, G02F 1/1368, G09F 9/00, G09F 9/30, H01L 29/41, H01L 29/417, H01L 29/786, H01L 51/50

(54) **FLEXIBLE SEMICONDUCTOR DEVICE, MANUFACTURING METHOD FOR SAME, AND IMAGE DISPLAY DEVICE**

(30) Priority: 14.05.2010 JP 2010112319; 14.05.2010 JP 2010112317
(71) Applicant: Panasonic Corporation, Kadoma-shi Osaka 571-8501 (JP)
(72) Inventor: SUZUKI, Takeshi, Osaka-shi Osaka 540-6207 (JP); HIRANO, Koichi, Osaka-shi Osaka 540-6207 (JP)
(74) Representative: Eisenführ, Speiser & Partner
(86) International application number: PCT/JP2011/002368
(87) International publication number: WO 2011/142089

(57) **Abstract**

There is provided a method for manufacturing a flexible semiconductor device. The method of the present invention comprises the steps of: (A) providing a metal foil; (B) forming an insulating layer on the metal foil, the insulating layer having a portion serving as a gate insulating film; (C) forming a supporting substrate on the insulating layer; (D) etching away a part of the metal foil to form a source electrode and a drain electrode therefrom; (E) forming a semiconductor layer in a clearance portion located between the source electrode and the drain electrode by making use of the source and drain electrodes as a bank member; and (F) forming a resin film layer over the insulating layer such that the resin film layer covers the semiconductor layer, the source electrode and the drain electrode. In the step (F), a part of the resin film layer interfits with the clearance portion located between the source and drain electrodes.

## Description

### TECHNICAL FIELD

The present invention relates to a flexible semiconductor device with its flexibility, and also a method for manufacturing the same. In particular, the present invention relates to the flexible semiconductor device which can be used as a TFT, and also the method for manufacturing the same. Furthermore, the present invention relates to an image display device using such a flexible semiconductor device.

### BACKGROUND OF THE INVENTION

There is a growing need for a flat-panel display for use in a computer with a wide spreading use of information terminals. With further advancement of informatization, there are also increasing opportunities in which information, which has been conventionally provided by paper medium, is digitized. Particularly, the needs for an electronic paper or a digital paper have been recently increasing since they are thin and light weight mobile display media which can be easily held and carried (see Patent document 1, described below).

Generally, the display medium of a flat panel display device is formed by using an element such as a liquid crystal, an organic EL (organic electroluminescence) and an electrophoresis. In such display medium, a technology which uses an active drive element (TFT element) as an image drive element has become a mainstream to secure a uniformity of the screen luminosity and a screen rewriting speed and so forth. For example, in the conventional display device for use in the computer, TFT elements are formed on a substrate wherein a liquid crystal element, an organic EL element or the like is sealed.

As a TFT element, semiconductors including a-Si (amorphous silicon) and p-Si (polysilicon) can be mainly used. These Si semiconductors (together with metal films, as necessary) are subjected to a multilayering process wherein each of a source electrode, a drain electrode and a gate electrode is sequentially stacked on the substrate, which leads to an achievement of the production of the TFT element.

Such method of manufacturing a TFT element using Si materials includes one or more steps with a high temperature, so that there is needed an additional restriction that the material of the substrate should resist a high process temperature. For this reason, it is required in practice to use a substrate made of a high heat-resistant material (e.g., a glass substrate). In the meanwhile, it may be possible to use a quartz substrate. However a quartz substrate is so expensive that an economical problem arises when scaling up of the display panels. Therefore, the glass substrate is generally used as the substrate for forming such TFT elements.

However, when the thin display panel as described above is produced by using the conventionally known glass substrate, there is a possibility that such display panel will have a heavy weight, lack flexibility and break due to a shock when it is fallen down. These problems, which are attributable to the formation of a TFT element on the glass substrate, are so undesirable in light of the needs for a portable thin display having lighter weight with the advancement of informatization.

From the standpoint of obtaining a substrate having flexibility and light weight to meet the needs for a lightweight and thin display, there is developed a flexible semiconductor device wherein TFT elements are formed on a resin substrate (i.e., plastic substrate). For example, Patent document 2 (see below) discloses a technique in which a TFT element is firstly formed on a substrate (i.e., glass substrate) by a process which is almost the same as conventional process, and subsequently the TFT element is peeled from the glass substrate so that it is transferred onto a resin substrate (i.e. plastic substrate). In this technique, the glass substrate wherein the TFT element is provided thereon is adhered to a resin substrate via a sealing layer (e.g., an acrylic resin layer), and subsequently the glass substrate is peeled thereoff. In this way, the TFT element is transferred onto the resin substrate.

In the method for manufacturing a TFT element using such a transference process, there is, however, a problem associated with the peeling of the substrate (i.e., glass substrate). In other words, it is necessary to perform an additional treatment to decrease the adhesion between the substrate and the TFT element upon the peeling of the substrate from the resin substrate. Alternatively it is necessary to perform an additional treatment to form a peel layer between the substrate and the TFT element and thus also necessary to physically or chemically remove the peel layer afterward. These additional treatments can make the process complicated, so that another problem associated with the productivity could also be caused.

### PATENT DOCUMENTS (PRIOR ART PATENT DOCUMENTS)

[Patent document 1] Japanese Unexamined Patent Publication (Kokai) No.2007-67263; and
[Patent document 2] Japanese Unexamined Patent Publication (Kokai) No.2004-297084.

### SUMMARY OF THE INVENTION

### PROBLEMS TO BE SOLVED BY THE INVENTION

In the production of the flexible semiconductor device, it is considered to directly form a TFT element on the resin substrate (or plastic plate), not transferring the TFT element onto the resin substrate. In this case, a peeling step (or removing step) of the supporting plate (i.e., glass substrate) after the transferring becomes unnecessary, and thus the flexible semiconductor device can be simply and easily manufactured.

However, since the resin substrate made of the acrylic resin or the like has a low heat-resistance, the process temperature is restricted to be kept as low as possible upon producing the TFT elements. Therefore, the TFT element which has been directly formed on the resin substrate can cause a problem in terms of a lowered TFT performance, as compared with that of the TFT elements obtained through the transference process.

For example, it is desired to subject the semiconductor material to a heat treatment in order to improve the semiconductor properties (e.g., mobility). However, in the case where the TFT element is directly formed on the resin substrate, it is difficult to adopt such heat treatment because of the restricted process temperature. Moreover, in order to decrease a gate voltage, it is desired to use, as a gate insulating film, an inorganic oxide with not only its high dielectric strength voltage, but also its thin thickness and moreover its high dielectric constant. However, such inorganic oxide can cause such a challenging problem to be greatly improved in terms of the production thereof that it is not easy to perform a machining process (e.g., laser machining process for forming a hole) due to the fact that the inorganic oxides generally have a densified form and a high chemical stability. In particular, such problem becomes severe when it comes to the flexible semiconductor device used for a large sized screen.

Moreover, the positioning of the semiconductor layer can be important from the viewpoint of the production of the flexible semiconductor device. When the accuracy of the positioning is inferior, no desirable TFT performance can be obtained, which could cause another problem in terms of a manufacturing yield of the flexible semiconductor device.

Furthermore, the flexible semiconductor device, which is composed of a plurality of laminated layers, is required to prevent the layers from causing their misalignment to attain an improved tight adhesiveness (or firm adhesiveness) between the layers.

The inventors of the present application tried to dissolve such problems not by following up the conventional way, but by focusing on a new way. The present invention has been accomplished in view of the above matters, and thus a main object of the present invention is to provide a method for manufacturing a flexible semiconductor device which is excellent in productivity, and also to provide a flexible semiconductor device with a high performance by such method.

### MEANS FOR SOLVING THE PROBLEM

In order to solve the above-mentioned problems, the present invention provides a method for manufacturing a flexible semiconductor device, the method comprising the steps of:
(A) providing a metal foil;
(B) forming an insulating layer on the metal foil, the insulating layer having a portion serving as a gate insulating film;
(C) forming a supporting substrate on the insulating layer;
(D) etching away a part of the metal foil to form a source electrode and a drain electrode from the metal foil;
(E) forming a semiconductor layer in a clearance portion located between the source electrode and the drain electrode by making use of the source and drain electrodes as a bank member; and
(F) forming a resin film layer over the insulating layer such that the resin film layer covers the semiconductor layer, the source electrode and the drain electrode,
wherein, in the step (F), a part of the resin film layer is forced to interfit with the clearance portion located between the source and drain electrodes.

The manufacturing method of the present invention is characterized in that the clearance portion between the source and drain electrodes is formed, and such clearance portion is suitably utilized for the purpose of manufacturing the flexible semiconductor device. More specifically, the source and drain electrodes between which "clearance portion" intervenes are utilized as a bank member, the clearance portion being obtained by the etching process of the metal foil, and thereby the semiconductor layer is formed such that the semiconductor layer is accommodated in the clearance portion.

The term *"flexible"* of the "flexible semiconductor device" used in the present description substantially means that the semiconductor device has such flexibility characteristic that the device can be inflected. The *"flexible semiconductor device"* of the present invention may also be referred to as "flexible semiconductor element", in view of the structure thereof.

The term *"bank member"* used in the present description, which is derived from the bank (i.e., the slope of land adjoining a body of water), substantially means a member serving as "positioning" of raw materials/materials of the semiconductor layer. The *"clearance portion"* which gives the bank member is one provided by an etching process of the metal foil with the intention to perform such "positioning", so that it should be noted that the *"clearance portion"* does not correspond to a scratch, a dimple, gap or the like which could be inevitably or accidentally formed upon the producing process.

In one preferred embodiment, with respect to faces of the source and drain electrodes, opposed end faces thereof between which the clearance portion intervenes is formed to have an inclined form in the step (D). For example, a photolithography process and an etching process are performed so that the opposed faces have the inclined form. More specifically, by performing the wet etching, the inclination of the end faces of the source and drain electrodes is given so that the clearance portion has a tapered shape.

In the forming step (F) of the resin film layer, for example, a resin film is laminated over the insulating layer, and thereby forcing a part of the resin film to interfit with the clearance portion. Just as an example, a resin film layer precursor is used, in which case the resin film layer precursor is laminated onto the supporting substrate equipped with the insulating layer while being pressed so that a part of the resin film layer precursor is forced to be embedded into the clearance portion which is located between the source and drain electrodes and above the supporting substrate. Such formation of the resin film layer can be performed by a roll-to-roll process.

With respect to the formation of a gate electrode, after a removal of the supporting substrate, the gate electrode can be formed on the surface of a portion of the insulating layer, the portion corresponding to the gate insulating film. In a case where a metal substrate is used as the supporting substrate, the gate electrode can be formed by subjecting the metal substrate to a pattering process after the step (F).

In one preferred embodiment, a ceramic substrate or a metal substrate is used as the supporting substrate. In this embodiment, the heating of the semiconductor layer and/or gate insulating film can be positively performed. As for the heating of the semiconductor layer, after the step (E), the semiconductor layer provided above the supporting substrate can be subjected to the heat treatment. It is preferred that the semiconductor layer (i.e., the semiconductor layer provided above the supporting substrate made of ceramic or metal) is subjected to an annealing treatment by irradiating it with a laser at a point in time between steps (E) and (F). This heating treatment can cause the modification of a film quality or property of the semiconductor layer, which leads to an achievement of the improved properties of the semiconductor layer. For example, the modification of the semiconductor layer makes it possible to improve the crystallinity of the semiconductor layer. The term *"anneal treatment"* used in the present description substantially means a heat treatment intended to improve or stabilize the properties such as "crystalline state", "degree of crystallization" and/or "mobility". As for the heating of the insulating layer, after the step (B), the gate insulating film is subjected to the heating treatment. It is preferred that the gate insulating film (insulating layer) is subjected to an annealing treatment by irradiating it with a laser. The heating of the insulating layer may be performed at a point in time not only between the step (D) and the step (E), but also between the step (E) and the step (F). In other words, not only the gate insulating film may be directly subjected to the heat treatment (especially "annealing treatment"), but also the gate insulating film may be subjected to the heat treatment (especially "annealing treatment") by a heat from the semiconductor layer upon the heating treatment of the semiconductor layer. Moreover, the heating of the insulating layer may also be performed at a point in time between the step (B) and the step (C). That is, the insulating layer provided over the metal foil may be directly subjected to the heat treatment.

In another preferred embodiment, the insulating layer made of an inorganic material in which the gate insulating film is provided is formed in the step (B). For example, the insulating layer with the gate insulating film may be formed by a sol-gel process. Alternatively, the insulating layer with the gate insulating film may be formed by locally subjecting a valve metal of the metal foil to an anodic oxidation treatment.

The present invention further provides a flexible semiconductor device obtained by the above manufacturing method. Such flexible semiconductor device comprises:
a gate electrode;
an insulating layer disposed on the gate electrode, the insulating layer having a portion serving as a gate insulating film; and
a source electrode and a drain electrode provided on the insulating layer, the source and drain electrodes being formed of a metal foil,
wherein there is provided a clearance portion between the source electrode and the drain electrode, and thereby the source and drain electrodes between which the clearance portion intervenes are a bank member;
a semiconductor layer is provided in the clearance portion; and
a resin film layer is provided over the insulating layer such that the semiconductor layer, the source electrode and the drain electrode are covered with the resin film layer, and the resin film layer has a protruding portion which is interfitted with the clearance portion.

For one thing, the flexible semiconductor device of the present invention is characterized in that the clearance portion is provided between the end face of the source electrode and the end face of the drain electrode wherein the semiconductor layer is provided such that it is accommodated in the clearance portion. That is, the semiconductor layer is provided to occupy the space between the source and drain electrodes which are disposed apart from each other.

As described above, the "bank member composed of the source and drain electrodes between with the clearance portion intervenes" corresponds to an electrode element provided with a view to the positioning of the material. Especially, the bank member corresponds to two kinds of the electrode elements which has functioned as the positioning member for the material of the semiconductor layer. In other words, the flexible semiconductor device of the present invention is configured to accommodate the semiconductor layer between the two kinds of bank electrodes, i.e., the source and drain electrodes. The clearance portion associated with the bank member preferably has a tapered shape, in which case opposed end faces of the source and drain electrodes, between which the clearance portion intervenes, are inclined. More specifically, the clearance portion in itself has a tapered shape, and thereby the end faces of the source and drain electrodes are inclined.

The flexible semiconductor device of the present invention is configured to dispose the resin film layer having flexibility over the insulating layer such that the semiconductor layer, the source electrode and the drain electrode are covered with the resin film layer. Such resin film layer is provided with a protruding portion interfitted with the clearance portion between the source and drain electrodes. More specifically, the protruding portion of the resin film layer is complementarily interfitted with the clearance portion. In other words, the protruding portion of the resin film layer and the clearance portion located between the source and drain electrodes have complementary form with respect to each other, and thereby the space of the clearance portion (i.e., clearance space other than the filled portion of the semiconductor layer in the clearance portion) is filled with the body of the protruding portion of the resin film layer.

The semiconductor layer in the flexible semiconductor device of the present invention may comprise a silicon or an oxide semiconductor (e.g., ZnO or InGaZnO).

In the flexible semiconductor device of the present invention, the insulating layer which includes the gate insulating film is made of an inorganic material. Preferably, the insulating layer with the gate insulating film may be one obtained by locally oxidizing the metal foil. In this case, the metal foil may comprise a valve metal material, and thus the insulating layer or gate insulating film may be an anodically-oxidized film of the valve metal. In another embodiment, the insulating layer or gate insulating film may be an oxide film obtained from a sol-gel process.

The present invention further provides an image display device in which the above flexible semiconductor device is used. Such image display device comprises:
the flexible semiconductor device; and
an image display unit composed of a plurality of pixels, the unit being provided over the flexible semiconductor device,
wherein the clearance portion is provided between the source and drain electrodes of the flexible semiconductor device, and thereby the source and drain electrodes between which the clearance portion intervenes are the bank member;
the semiconductor layer of the flexible semiconductor device is provided in the clearance portion; and
the resin film layer of the flexible semiconductor device is provided with the protruding portion which is interfitted with the clearance portion.

### EFFECT OF THE INVENTION

In accordance with the manufacturing method of the present invention, the semiconductor layer can be suitably arranged by the using of the source and drain electrodes between which the clearance portion intervenes. Particularly, the semiconductor layer can be relatively easily formed at the desired position since the "source and drain electrodes between which the clearance portion intervenes" can serve as the bank for the "positioning" thereof. Specifically, the following matters (I) and (II) are possible:
(I) In a case where the semiconductor layer is formed through a thin film formation process or a printing process, the deposition of the semiconductor materials can be performed within the clearance portion and thus such deposited materials may be used as the semiconductor layer. This makes it possible to perform an effective positioning of the semiconductor layer formation; and
(II) In a case where the raw material for the semiconductor layer is in a paste form or in a liquid form, the supplied raw material to the clearance portion can be held in place without being allowed to flow out of the clearance portion. This makes it possible to facilitate the formation of the semiconductor layer at the predetermined position (i.e., at the clearance portion).
Especially as for the above (II), the clearance portion can also serve to hold the liquid raw materials of the semiconductor upon the formation of the semiconductor layer, and thus the clearance portion can function as the bank for "storing" (or as "storage bank") as well as the bank for "positioning" (as "positioning bank").

According to the manufacturing method of the present invention, the source and drain electrodes serving as the positioning bank can be used directly as the electrodes of the TFT i.e., the constituent element of the flexible semiconductor device. This means that there is no need to finally remove or peel off the bank member which has contributed to the formation of the semiconductor layer, and thereby the TFT element can be manufactured by simple and easy process, which leads to an achievement of the improved productivity thereof.

According to the manufacturing method of the present invention, a part of the resin film layer is forced to be interfitted with the clearance portion of the bank member i.e., the source and drain electrodes, and thereby making it possible to provide an effect of preventing the resin film layer from to be peeled off. Such effect is due to the complementary interfitting between "protruding portion of the resin film layer" and "clearance portion". Such structural feature can improve the tight adhesiveness in the resin film layer. In other words, the present invention can improve the tight adhesiveness of the laminated structure by the "source and drain electrodes between which the clearance portion intervenes" serving as the bank member.

The improved tight adhesiveness of the laminated structure particularly provides an advantageous effect when the flexible semiconductor is subjected to a bent condition (e.g., a roll-to-roll process). That is, the peeling of the layer can be effectively prevented even when the laminated structure is subjected to a severe manufacturing condition where the peeling is induced. This also leads to the improved productivity.

Since the lamination of the obtained flexible semiconductor device is firmly hold, a degradation of the performance resulted from the "peeling" can be prevented. The flexible semiconductor device is usually used in a bent condition. In this regard, the present invention can suitably prevent such peeling by the "source and drain electrodes between which the clearance portion intervenes" serving as the bank member, which leads to an achievement of a high bending-resistance of the flexible semiconductor device.

Moreover, according to the present invention, the heating (particularly preferably "anneal heating") of the gate insulating film and/or the semiconductor layer can be suitably performed to improve the properties thereof, since the metal foil or supporting substrate (especially the supporting substrate made of ceramic or metal) is used in spite of the flexible semiconductor device. That is, there can be obtained an effectively improved performance in the flexible semiconductor device.

### BRIEF DESCRIPTION OF DRAWINGS

Fig. 1(a) schematically illustrates a perspective cross sectional view of a flexible semiconductor device 100 according to an embodiment of the present invention, showing the structure of the device. Fig. 1(b) illustrates a top plan view for explaining a transistor structure around the clearance portion 50 of the device.
Figs. 2(a) to 2(d) illustrate cross-sectional views showing the steps in a manufacturing process of a flexible semiconductor device 100 according to an embodiment of the present invention.
Figs. 3(a) to 3(c) illustrate cross-sectional views showing the steps in a manufacturing process of a flexible semiconductor device 100 according to an embodiment of the present invention.
Fig. 4 schematically illustrates an embodiment of "clearance portion" which functions as a positioning bank member for determining the formed position of a semiconductor layer.
Fig. 5 (a) schematically illustrates a perspective cross sectional view of a flexible semiconductor device 100 according to an embodiment ("mask embodiment") of the present invention, showing the structure of the device. Fig. 5 (b) schematically illustrates "coincidence of self-alignment" characterized by an embodiment ("mask embodiment") of the present invention. Fig. 5 (c) schematically illustrates a top plan view for explaining a transistor structure around the clearance portion 50.
Figs. 6(a) to 6(d) illustrate cross-sectional views showing the steps in a manufacturing process of a flexible semiconductor device 100 according to an embodiment ("mask embodiment") of the present invention.
Figs. 7(a) to 7(c) illustrate cross-sectional views showing the steps in a manufacturing process of a flexible semiconductor device 100 according to an embodiment ("mask embodiment") of the present invention.
Figs. 8(a) and 8(b) illustrate cross-sectional views showing the steps in a manufacturing process of a flexible semiconductor device 100 according to an embodiment ("mask embodiment") of the present invention.
Fig. 9 illustrates a view for explaining an advantageous effect provided by the inclined faces of the source and drain electrode upon the light irradiation (according to "mask embodiment" of the present invention).
Figs. 10(a) to 10(d) illustrate cross-sectional views showing the steps in a manufacturing process of a flexible semiconductor device 100' according to an embodiment ("mask embodiment") of the present invention.
Figs. 11(a) to 11(c) illustrate cross-sectional views showing the steps in a manufacturing process of a flexible semiconductor device 100' according to an embodiment ("mask embodiment") of the present invention.
Figs. 12(a) and 12(b) illustrate cross-sectional views showing the steps in a manufacturing process of a flexible semiconductor device 100' according to an embodiment ("mask embodiment") of the present invention.
Fig. 13 illustrates a circuit diagram in a drive circuit 90 of an image display device according to an embodiment of the present invention.
Fig. 14 (a) illustrates cross-sectional views an example of laminated structure 200 wherein a drive circuit of an image display device consists of a flexible semiconductor device 100. Fig. 14 (b) illustrates cross-sectional views an example of laminated structure 200 according to an embodiment ("mask embodiment") of the present invention.
Fig. 15A (a) illustrates a plan view of layer 101 of laminated structure 200. Fig. 15A (b) illustrates a plan view of layer 101 of laminated structure 200 according to "mask embodiment".
Fig. 15B (a) illustrates a plan view of layer 102 of laminated structure 200. Fig. 15B (b) illustrates a plan view of layer 102 of laminated structure 200 according to "mask embodiment".
Fig. 15C (a) illustrates a plan view of layer 103 of laminated structure 200. Fig. 15C (b) illustrates a plan view of layer 103 of laminated structure 200 according to "mask embodiment".
Fig. 15D (a) illustrates a plan view of layer 104 of laminated structure 200. Fig. 15D (b) illustrates a plan view of layer 104 of laminated structure 200 according to "mask embodiment".
Fig. 15E (a) illustrates a plan view of layer 105 of laminated structure 200. Fig. 15E (b) illustrates a plan view of layer 105 of laminated structure 200 according to "mask embodiment".
Fig. 16(a) illustrates cross-sectional view of laminated structure 200 taken along the line VII-VII. Fig. 16(b) illustrates cross-sectional view of laminated structure 200 taken along the line XI-XI.
Fig. 17(a) illustrates cross-sectional view of laminated structure 200 taken along the line VIII-VIII. Fig. 17(b) illustrates cross-sectional view of laminated structure 200 taken along the line XII-XII.
Fig. 18 schematically illustrates a cross-sectional view of an image display device according to the present invention.
Fig. 19 schematically illustrates a cross-sectional view of an image display device equipped with a color filter according to the present invention.
Figs. 20(a) to 20(e) illustrate cross-sectional views schematically showing the steps in a manufacturing process of an image display device according to the present invention.
Figs. 21(a) to 21(d) illustrate cross-sectional views schematically showing the steps in a manufacturing process of an image display device equipped with a color filter according to the present invention.
Fig. 22 schematically illustrates an embodiment where a flexible semiconductor device 100 according to an embodiment of the present invention is produced through the roll-to-roll process.
Fig. 23(a) illustrates an enlarged sectional view of a part of a lamination structure 110 which has been wound up by the roller 230. Fig. 23(b) illustrates an enlarged sectional view of a part of a lamination structure 110, according to "mask embodiment", which has been wound up by the roller 230.
Fig. 24 illustrates an example of a product (an image display part of a television) wherein a flexible semiconductor device of the present invention is used.
Fig. 25 illustrates an example of a product (an image display section of a cellular phone) wherein a flexible semiconductor device of the present invention is used.
Fig. 26 illustrates an example of a product (an image display section of a mobile personal computer or a laptop computer) wherein a flexible semiconductor device of the present invention is used.
Fig. 27 illustrates an example of a product (an image display section of a digital still camera) wherein a flexible semiconductor device of the present invention is used.
Fig. 28 illustrates an example of a product (an image display section of a camcorder) wherein a flexible semiconductor device of the present invention is used.
Fig. 29 illustrates an example of a product (an image display section of an electronic paper) wherein a flexible semiconductor device of the present invention is used.

### DETAILED DESCRIPTION OF THE INVENTION

Hereinafter, some embodiments of the present invention will be illustrated with reference to Figures. In the following Figures, the same reference numeral indicates the element which has substantially the same function for simplified explanation. The dimensional relationship (length, width, thickness and so forth) in each Figure does not reflect a practical relationship thereof.

Each "direction" referred to in the present description (especially "direction" referred with respect to the manufacturing method of the present invention) means the direction based on the spatial relationship between the insulating layer 10 and the semiconductor layer 20, in which each of upward direction and downward direction is mentioned relating to the direction in the drawings for convenience. Basically, the upward direction and the downward direction respectively correspond to the upward direction and the downward direction in each drawing. The side on which the semiconductor layer 20 is formed based on the insulating layer 10 is referred to as "upward direction", and whereas the side on which the semiconductor layer 20 is not formed based on the insulating layer 10 is referred to as "downward direction".

### 〈〈Embodiment of Present Invention wherein Source and Drain Electrodes with Clearance Portion are used as Bank member〉〉

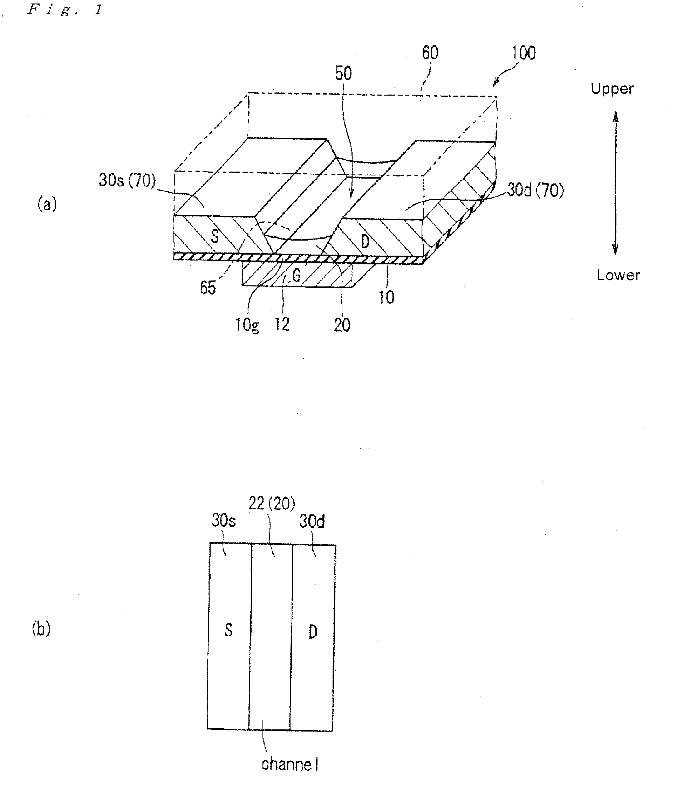

Referring to Figs. 1 (a) and 1(b), a flexible semiconductor device 100 according to an embodiment of the present invention will be explained. Fig. 1 (a) is a perspective view schematically illustrating the structure of the flexible semiconductor device 100 of the present invention. Fig. 1 (b) shows a relationship among a source 30s, a channel 22(20) and a drain 30d of the flexible semiconductor device 100.

The flexible semiconductor device 100 according to the embodiment of the present invention has flexibility. As shown in Fig 1(a), the flexible semiconductor device 100 comprises an insulating layer 10 having a portion serving as a gate insulating film 10g, and a source electrode 30s and a drain electrode 30d both of which are formed of a metal foil 70. The source electrode 30s and the drain electrode 30d are provided on the insulating layer 10.

Between the source electrode 30s and the drain electrode 30d, a clearance portion 50 is provided. According to the embodiment of the present invention, the source and drain electrodes 30s, 30d between which the clearance portion 50 intervenes serve as a bank member. That is, the clearance portion 50 functions as a positioning bank which determines the formed location of the semiconductor layer during the formation thereof. In a case where the semiconductor raw material is in a liquid form, the clearance portion 50 additionally functions as a storage bank.

As shown in Fig. 1(a), the semiconductor layer 20 is provided such that it occupies at least a part of the clearance portion 50. In Fig. 1(a), the shape of the clearance portion 50 is shown by illustrating the semiconductor layer 20 in a form of transparency. A resin film layer 60 is formed over the insulating layer 10 such that the semiconductor layer 20, the source electrode 30s and the drain electrode 30d are covered with the resin film layer. The resin film layer 60 is shown by a dotted line (chain double-dashed line) so as to clearly show the clearance portion 50.

As can be seen from the embodiment shown in Fig. 1 (a), a part of the resin film layer 60 forms a protruding portion 65 (i.e., bulge portion) which is interfitted with the clearance portion 50. Particularly, the protruding portion 65 of the resin film layer 60 and the clearance portion 50 interdigitate with each other to form a complementary form in the flexible semiconductor device 100 of the present invention. Thus, the interdigitate structure between the protruding portion 65 and the clearance portion 50 makes it possible to improve the tight adhesiveness between "resin film layer 60" and "structure including the source and drain electrodes 30s, 30d". In other words, the improved adhesion of the laminated structure in the flexible semiconductor device 100 is achieved due to the presence of the clearance portion 50.

The gate electrode 12 is provided on the opposite side of the insulating layer 10 from the provision of the semiconductor layer 20. In other words, the gate electrode 12 is located on the surface of a portion of the insulating layer 10, the portion serving as an insulating resin film 10g.

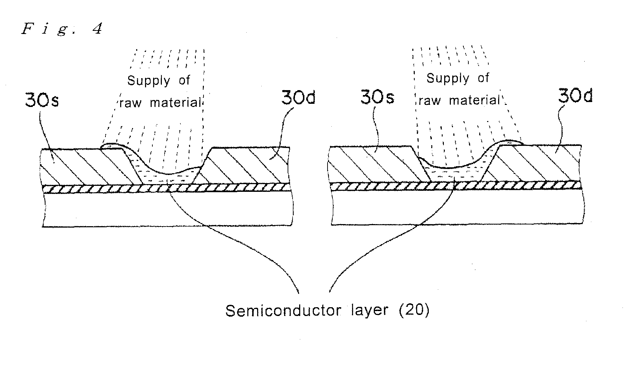

The semiconductor layer 20 according to the present invention is obtained by allowing the clearance portion to serve as the bank. For example, in a case where the formation of the semiconductor layer is performed at a clearance region in a thin film formation process or a printing process, the semiconductor material can deposit in the clearance portion 50 regardless of the any supply deviation of the raw material, and thereby the deposited material can be suitably utilized as the semiconductor layer. Therefore, the clearance portion 50 is capable of functioning as the positioning bank which determines the formed location of the semiconductor layer (see Fig. 4). For example, in a case where the semiconductor layer 20 made of silicon (Si) is formed, it be formed by supplying the liquid silicon into the clearance portion 50, in which case the clearance portion 50 can also function as a storage for the liquid silicon. In other words, in a case of the semiconductor raw material being in a paste form or in a liquid form, the clearance portion 50 can not only serve as the "positioning element" which functions to determine the positioning of the semiconductor raw material, but also serve as the "storage element" which functions to store (reserve) the supplied semiconductor raw material.

As a semiconductor material for the semiconductor layer 20 in the flexible semiconductor device of the present invention, the above-mentioned silicon (Si) may be used, but any other suitable materials may also be used. For example, the semiconductor layer may be made of the semiconductor material such as germanium (Ge), or an oxide semiconductor material. The oxide semiconductor may be an elementary oxide such as ZnO, SnO₂, In_{2O3} and TiO₂, or a composite oxide such as InGaZnO, InSnO, InZnO and ZnMgO. As needed, a compound semiconductor may also be used, in which case a compound thereof is for example GaN, SiC, ZnSe, CdS, GaAs and so forth. Furthermore, an organic semiconductor may also be used, in which case an organic compound thereof is for example pentacene, poly-3-hexyl-thiophene, porphyrin derivatives, copper phthalocyanine, C60 and so forth.

The insulating layer 10 in which the gate insulating film 10g is included is made of inorganic material in the flexible semiconductor device of the present invention. For example in a case of the semiconductor layer 20 made of silicon (Si), the gate insulating film 10g may be a silicon oxide film (SiO₂) or a silicon nitride film. The gate insulating film 10g can be formed by a sol-gel process. Alternatively, the gate insulating film 10g may be an oxide film formed by subjecting the metal foil 70 to an anodic oxidization treatment.

The structure around the clearance portion 50 in the flexible semiconductor device of the present invention, when seen from the above, can be illustrated as shown in Fig. 1 (b). The semiconductor layer 20 is provided on the gate insulating film 10g at the region of the clearance portion 50. The source electrode 30s and the drain electrode 30d are in contact with the semiconductor layer 20. At the lower surface of the semiconductor layer 20 (i.e., at the bottom surface of the semiconductor layer), there is provided the gate insulating film 10g and the gate electrode 12. Thus, a portion of the semiconductor layer 20, which is located between the source electrode 30s and the drain electrode 30d, can function as a channel region 22, which thus provides the device with a transistor (a thin-film transistor: TFT).

The resin film layer 60 according to the flexible semiconductor device of the present invention is made of resin material which has flexibility. Particularly, the resin film layer 60, which can also serve as a supporting substrate for the transistor structure including the semiconductor layer 20, may be made of thermosetting resin materials or thermoplastic resin materials which provide the film layer with flexibility after being cured. Examples of such resin materials include, for example, an epoxy resin, a polyimide (PI) resin, an acrylic resin, a polyethylene terephthalate (PET) resin, a polyethylene naphthalate (PEN) resin, a polyphenylene sulfide (PPS) resin, polyphenylene ether (PPE) resin, a fluorinated resin (e.g., PTFE), a liquid crystal polymer, a composite thereof and the like. Alternatively, the resin film layer 60 may be made of an organic/inorganic-hybrid material which contains polysiloxane. The resin materials as described above are excellent in the dimensional stability and thus are preferably used as flexible materials of the flexible semiconductor device.

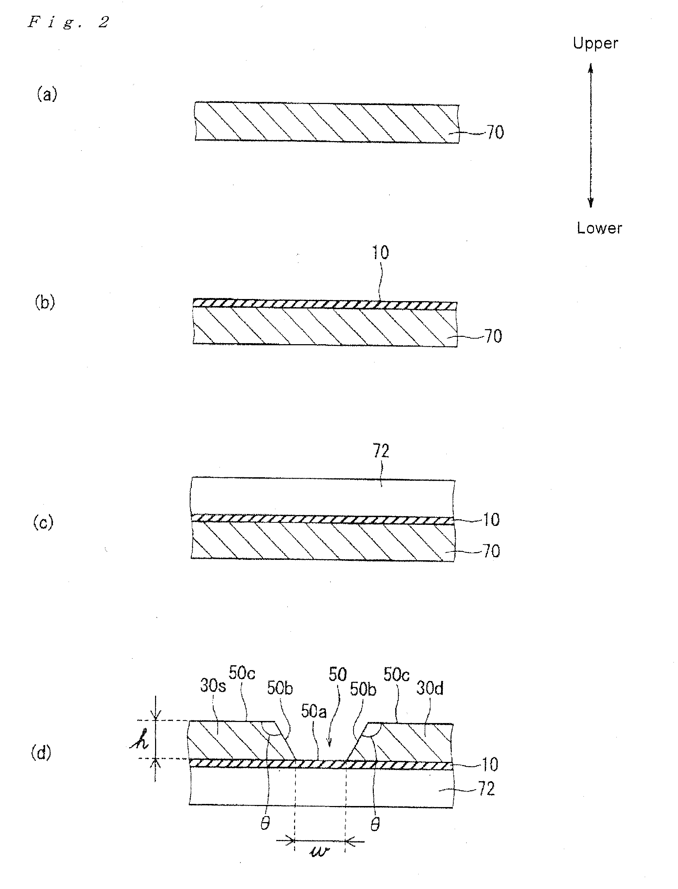

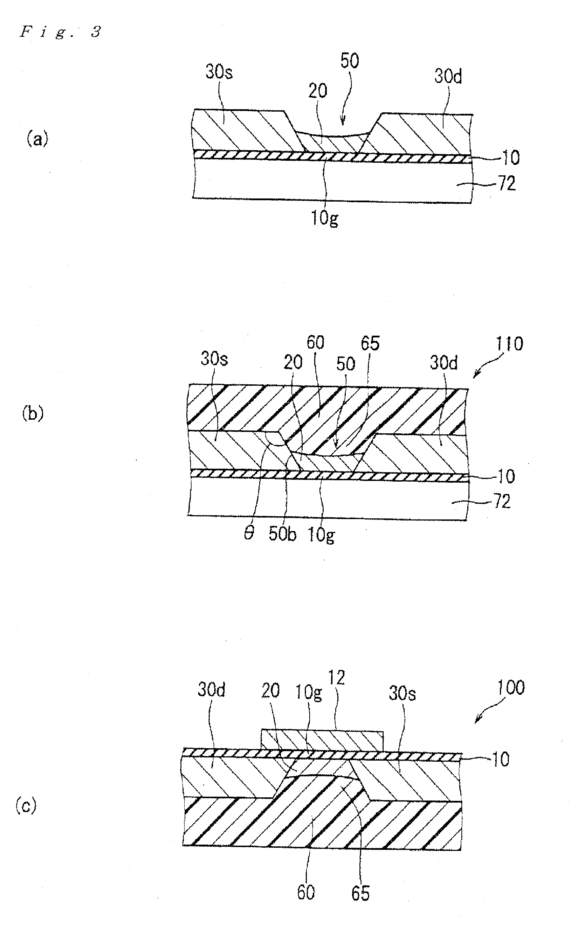

Next, with reference to Figs. 2(a) to 2(d) and Figs. 3(a) to 3(c), the manufacturing method of the flexible semiconductor device 100 according to the present invention will be explained. Figs. 2(a) to 2(d) and Figs. 3(a) to 3(c) respectively show cross-sectional views illustrating the steps in the manufacturing process of the flexible semiconductor device 100.

Upon carrying out the manufacturing method of the present invention, the step (A) is firstly performed. That is, a metal foil 70 is provided as shown in Fig. 2(a). For example, the metal foil 70 may be a copper foil or an aluminum foil. The metal foil 70 has a thickness in the range of about 0.5 µm to about 100 µm and preferably in the range of about 2 µm to about 20 µm, for example.

Subsequently, the step (B) is performed wherein an insulating layer 10 is formed on the surface of the metal foil 70 as shown in Fig. 2(b). The thickness of the insulating layer 10 may be in the range of about 30 nm to about 2 µm. The insulating layer 10 includes a portion serving as a gate insulating film 10g. For example, the insulating layer 10 may be a silicon oxide layer. In such case, a thin film made of silicon oxide may be formed with using TEOS, for example.

The insulating layer 10 having the gate insulating film in a part thereof can be formed of an inorganic material. That is, even though an organic insulating film is generally used as the gate insulating film in the flexible semiconductor device wherein a resin substrate is used as a supporting substrate, the present invention makes it possible to use an inorganic insulating film as the gate insulating film, which leads to an improvement of the transistor performance of the flexible semiconductor device 100.

The reason for the improved performance of the transistor is that the gate insulating film made of the inorganic material not only has an improved dielectrics strength voltage even if being in a thin thickness, but also has a higher permittivity, compared with the case of the gate insulating film made of the organic material. According to the TFT structure of the present invention, the insulating layer 10 is provided over the surface of the metal foil 70, which makes it possible to lower the restriction in terms of the process for forming the insulating layer 10. This means that, the present invention enables the readily formation of the gate insulating film made of an inorganic material. Moreover, after the formation of the insulating layer 10 on the metal foil 70, the insulating layer 10 can be subjected to an annealing treatment (i.e., thermal annealing treatment) to improve the quality thereof, since the metal foil 70 is located beneath the insulating layer 10.

Moreover, in a case where the metal foil 70 is made of aluminum, the insulating layer 10 can be formed by locally and anodically oxidizing the surface region of the metal foil 70. The insulating layer formed by the locally anodic oxidation may have the thickness in the range of about 30 nm to about 200 nm. Any suitable chemical conversion solutions can be used for the anodic oxidation of the aluminum, and thereby a dense and very thin oxidized film can be formed. For example, as the chemical conversion solution, a "mixed solution of aqueous tartaric acid solution and ethylene glycol" with an adjusted pH of around the neutral value by using of ammonia, may be used. The metal foil 70 from which the insulating layer 10 can be formed by the anodic oxidation is not only aluminum foil, but also any suitable metal foil which has a good electric conductivity and is capable of readily forming a dense oxide. For example, the metal foil 70 may be made of a valve metal. Examples of the valve metal include, but not limited to, at least one metal selected from the group consisting of aluminum, tantalum, niobium, titanium, hafnium, zirconium, molybdenum and tungsten, or an alloy thereof. In a case where the anodic oxidation is adopted, there can be provided an advantage in that an oxide film with an even thickness can be formed on the surface even when the surface of the metal foil 70 has a complicated form. Also, in the case of the anodic oxidation, there can be provided another advantage in that a gate insulating film with a higher permittivity can be formed, compared with that of a silicon oxide film.

Moreover, the material of the metal foil 70 is not limited to the valve metal material (e.g., aluminum material), but the metals of the foil may be those capable of giving an oxide film which is uniformly coated on the surface of the foil by an oxidation. Therefore, a metal other than the valve metal may be used. In this regard, the oxidation process of the metal foil 70 can be performed by a thermal oxidation (surface oxidation by heating treatment) or chemical oxidation (surface oxidation by an oxidizing agent) instead of the anodic oxidation.

Alternatively, the insulating layer 10 can be formed by performing a sol-gel process. The insulating layer formed by the sol-gel process may have the thickness in the range of about 100 nm to about 1 µm. In this case, the insulating layer 10 may be a silicon oxide film, for example. Jus as example of the case of the sol-gel process for forming the silicon oxide, it can be formed by evenly applying a colloidal solution (a sol-liquid), which has been prepared by stirring a mixture solution of tetraethoxysillane (TEOS), methyltriethoxysilane (MTES), ethanol and dilute hydrochloric acid (0.1 wt %) for 2 hours at room temperature, onto the metal foil by a spin-coating process and then is subjected to a heat treatment at 300°C for 15 minutes. According to such sol-gel process, there is provided an advantage in that it can produce a gate insulating film with a high permittivity (e.g., such as the silicon oxide film, a hafnium oxide film, an aluminum oxide film and a titanium oxide film with a high permittivity).

Subsequent to the formation of the insulating layer, a supporting substrate 72 is formed on the insulating layer 10 as shown in Fig. 2(c). That is, the step (C) in the manufacturing method of the present invention is performed. The supporting substrate 72 may be a ceramic substrate (e.g., substrate made of alumina (Al₂O₃), zirconia (ZrO)) or metal substrate (e.g., substrate made of stainless steel such as SUS304). Alternatively, a resin substrate may be used as the supporting substrate 72. For example, such ceramic or resin substrate may be laminated onto the insulating layer 10 (optionally with the use of an adhesive) so that the formation of the supporting substrate 72 on the insulating layer 10 can be suitably performed.

Subsequent to the formation of the supporting substrate, a part of the metal foil 70 is removed by subjecting the metal foil 70 to an etching treatment, and thereby a source electrode 30s and a drain electrode 30d are formed from the metal foil 70 as shown in Fig. 2(d). That is, the step (D) in the manufacturing method of the present invention is performed. Even when the etching of the metal foil 70 is performed, all of the source and drain electrodes and the insulating layer 10 are suitably held together by the supporting substrate 72 provided on one side of the insulating layer 10. In other words, all of them are prevented from splitting into pieces in spite of the etching of the metal foil 70.

The formation of the source and drain electrode 30s, 30d can be performed by a combination of a photolithography process and an etching process, for example. More detailed explanation about this is as follows: First, a photoresist film is formed on the whole surface of the metal foil 70 by using of photoresist materials such as a dry film or liquid type one. Then, by using of a photomask having desired shape and position corresponding to the source and drain electrodes 30s,30d, the photoresist film is subjected to a pattern-exposure process, followed by a development process. Subsequently, by making use of the resulting photoresist film having the desired pattern of the source and drain electrodes 30s,30d as a mask, the metal foil 70 is immersed in an etching solution, and thereby the source electrode 30s and the drain electrode 30d as well as the clearance portion 50 which intervenes therebetween are formed. Finally, by removing the photoresist film, there can be obtained "source and drain electrodes between which the clearance portion intervenes". For example, the etching solution may be suitably selected depending on the kind of the metal foil. Just as an example, a solution of ferric chloride, or a solution of sulfuric acid and hydrogen peroxide may be used in a case of a copper foil. In another case where of an aluminum foil, a mixed solution of phosphoric acid, acetic acid and nitric acid may be used.

According to the embodiment of the present invention, opposed end faces 50b of the source and drain electrodes 30s,30d, between which the clearance portion 50 intervenes, are inclined. In other words, as shown in Fig. 2(d), the surrounding portion of the clearance portion 50 is composed of a bottom face 50a, wall faces 50b and top faces 50c wherein the wall faces are inclined ones. The angle θ between the wall face 50b and the top face 50c is an obtuse angle. For example, the angle θ is in the range of about 100 degrees to about 170 degrees, preferably in the range of about 110 degrees to about 160 degrees (see Fig. 2(d)). The bottom width "w" of the clearance portion 50 as shown in Fig. 2(d) is preferably in the range of about 1 µm to about 1 mm, more preferably in the range of about 10 µm to about 300 µm. The depth (or height) "h" of the clearance portion 50 as shown in Fig. 2(d) is preferably in the range of about 0.5 µm to about 100 µm, more preferably in the range of about 2 µm to about 20 µm.

Subsequent to the formation of the source and drain electrodes, as shown in Fig. 3(a), a semiconductor layer 20 is formed in the clearance portion 50 by making use of the source and drain electrodes 30s, 30d as a bank member. That is, the step (E) in the manufacturing method of the present invention is performed. In the step (E), the semiconductor layer 20 can be suitably formed since the source and drain electrodes 30s, 30d between which the clearance portion 50 intervenes can function as the bank member for the "positioning" of the semiconductor layer.

Specifically, the semiconductor layer 20 is formed on a part of the insulating layer 10 (especially, on a gate insulating film 10g thereof), the part corresponding to the surrounding bottom face 50a of the clearance portion 50. The formed semiconductor layer 20 may have a thickness in the range of about 30 nm to about 1 µm, preferably in the range of about 50 nm to about 300 nm. In other words, the semiconductor layer 20 is formed to be accommodated in the clearance portion 50.

For example in a case where the semiconductor layer is formed by a thin film formation process or a printing process, the deposition of the semiconductor materials can be performed in the clearance portion 50, and thereby such deposited materials may be utilized as the semiconductor layer. In this case, the clearance portion 50 can serve to determine the positioning of the semiconductor layer formation (see Fig. 4). In other words, "source and drain electrodes between which the clearance portion 50 intervenes" serves as the bank member for the "positioning" of the semiconductor layer. Examples of the thin film formation process include, but not limited to, a vacuum deposition process, a sputtering process, a plasma CVD process and the like. While on the other hand, examples of the printing process include a relief printing process, a gravure printing process, a screen printing process, an ink jet process and the like.

In a case where the raw material for the semiconductor layer 20 is in a liquid form and thus it is supplied to the bottom face 50a, the supplied raw material can be held in the clearance portion 50 while preventing the material from flowing out of the clearance portion 50. In this case, the clearance portion 50 additionally functions to storage the liquid raw material for the semiconductor layer. Therefore, in the case where the raw material for the semiconductor layer is in a liquid form or in a paste form, the "source and drain electrodes between which the clearance portion 50 intervenes" serves as the bank member for the "storing" of the raw material in addition to the "positioning" of the semiconductor layer.

The formation of the semiconductor layer will be now specifically explained. In a case where the semiconductor layer 20 is formed as a silicon layer, a solution material containing a cyclic silane compound (e.g., a toluene solution of cyclopentasilane) for example is applied over the bottom face 50a of the clearance portion 50 by an ink jet process or the like. Subsequently, the applied material is subjected to a heat treatment at a temperature of 300°C, and thereby the semiconductor layer 20 made of amorphous silicon is formed.

At a point in time immediately after the formation of the semiconductor layer 20, it is in a situation where the semiconductor layer 20 is located above the metal foil 70 via the insulating layer 10. Thus, the layer 20 can be subjected to an annealing treatment. Such annealing treatment of the semiconductor layer 20 makes it possible to improve or modify a film quality of the semiconductor layer 20. Particularly in a case where the supporting substrate 72 is made of a ceramic or metal, the annealing treatment at a high temperature causes substantially no problem, since such substrate has a superior heat resistance property. Even in a case where the supporting substrate 72 is formed of a resin material, the annealing of the semiconductor layer 20 can be performed since it can still have a supporting function upon the annealing treatment thereof, in which case, although the deteriorated film quality of the supporting substrate 72 may be caused by the annealing treatment, such supporting substrate 72 is finally removed, and thereby posing no obstacle to the performance of the annealing treatment.

In a case where the semiconductor layer 20 made of the amorphous silicon is formed in the clearance portion 50, it can be modified to a polycrystalline silicon (for example, the polycrystalline silicon having its average particle diameter of a few hundred nm to about 2 micrometers) by the annealing treatment. In another case of the semiconductor layer 20 made of a polycrystalline silicon, the degree of the crystallization thereof can be improved by the annealing treatment. Moreover, the modification of the film quality of the semiconductor layer 20 can lead to an improved mobility of the semiconductor layer 20. This means that there may be a significant difference in the mobility of the semiconductor layer 20 between the before-annealing and the after-annealing.

In this regard, a brief explanation regarding the relationship Between the crystal particle diameter of the silicon semiconductor and the mobility is as follows, for example:
The mobility of a-Si (amorphous silicon) is less than 1.0 cm²/Vs. The mobility of µC-Si (microcrystalline silicon) is about 3 (cm²/Vs), and the crystal particle diameter thereof is in the range of 10 nm to 20 nm. The mobility of pC-Si (polycrystalline silicon) is about 100 (cm²/Vs) or in the range of about 10 to about 300 (cm²/Vs), and the crystal particle diameter thereof is in the range of about 50 nm to about 0.2 µm. Therefore, when the film quality is modified due to the annealing treatment from a-Si (amorphous silicon) to µC-Si (microcrystal silicon) or pC-Si (polycrystalline silicon), the mobility can increase by more than several times (i.e., several times, tens times, hundreds times and so on). Incidentally, the mobility of sC-Si (single crystal silicon) is about 600 (cm²/Vs) or more.

As the annealing treatment of the semiconductor layer, the metal foil 70 provided with the semiconductor layers 20 can be subjected to a heat treatment as a whole. Alternatively, by irradiating the clearance portion 50 with the laser light, the semiconductor layer 20 can be subjected to a heat treatment. In a case of the annealing treatment by the laser irradiation, the following procedure may be adopted for example: The semiconductor layer may be irradiated with an excimer laser (XeCl) having a wave length of 308 nm, 100 shots to 200 shots with an energy-density of 50 mJ/cm² and a pulse width of 30 nanoseconds. It should be noted that the specific conditions of the annealing treatment are suitably selected in light of the various factors.

The heat treatment of the insulating layer 10 (especially, gate insulating film 10g) can be simultaneously performed upon the heat treatment of the semiconductor layer 20. In other words, the anneal treatment of the semiconductor layer 20 and the anneal treatment of the insulating layer 10 may be simultaneously performed in the same process. The anneal treatment of the semiconductor layer 20 makes it possible to modify the film quality of the insulating layer 10 (especially, gate insulating film 10g). In this regard, when the semiconductor layer is heated, the gate insulating film 10 may also be heated due to the heat thereof. In a case where the insulating layer 10 is an oxide film (SiO₂) prepared by a thermal oxidation (wet oxidation) in the steam, the electron trap level of the oxide film (SiO₂) can be reduced by heating of the insulating layer 10. Further explained in this regard, the wet oxidation is preferable since the productivity is superior due to an oxidizing velocity being about 10 times as high as that of the dry oxidation. But, the wet oxidation has a tendency that the electron trap level increases. While on the other hand, the dry oxidation has so much hole traps, in spite that the generation of the electronic trap level is lowered. Accordingly, a gate oxide film having fewer electron traps and fewer hole traps can be produced with sufficient productivity by performing, under an oxygen atmosphere, the heat treatment of the oxide film produced by the wet oxidation.

Subsequent to the formation of the semiconductor layer 20 (and the heating treatment thereof), a resin film layer 60 is formed. That is, the step (F) in the manufacturing method of the present invention is performed. Specifically, as shown in Fig. 3(b), the resin film layer 60 is formed such that it covers the source electrode 30s, the drain electrode 30d and the semiconductor layer 20. As a result, a film-laminated structure (flexible substrate structure) 110 is obtained. According to the present invention, a part of the resin film layer 60 is forced to be inserted into the clearance portion 50 upon the formation of the resin film layer 60. That is, the formation of the resin film layer 60 is performed so that the inside of the clearance portion 50 is filled with the material body of the resin film. This means that the resin film layer 60 is provided to have the protruding portion 65 which interdigitates with the clearance portion 50. Such interdigitate structure between the protruding portion 65 and the clearance portion 50 can improve the tight adhesiveness between "resin film layer 60" and "transistor structure including the source and drain electrodes 30s, 30d".

The angle θ (see Fig. 2(d)) regarding the opposed faces defining the clearance portion 50 is an obtuse angle according to the present invention, and thereby the insertion of a part of the resin film 60 into the clearance portion 50 is facilitated as compared with the case where the angle θ is a right angle. This is desirable since the formation of the interfitting (interdigitating) between the protruding portion 65 and the clearance portion 50 can be promoted. In the case where the angle θ is an obtuse angle, the function of the source and drain electrodes 30d, 30d as the bank member upon the formation of the semiconductor layer 20 may be further improved compared with the case where the angle θ is a right angle. Specifically, even when the positional precision of the supply device is inferior (or the supply device has significant tolerance) in terms of the supplying of the semiconductor materials into the clearance portion 50, the structure where the angle θ is an obtuse angle can improve such positional precision of the formed semiconductor layer 20. The reason for this is that the region for receiving the supplied material can be enlarged due to the presence of the clearance portion wherein the angle θ is an obtuse.

Examples of the formation process for the resin film layer 60 include, but not limited to, a process of laminating a semi-cured resin film onto the insulating layer 10, followed by being cured (wherein an adhesive material may be applied to a laminating surface of the resin sheet), and a process of applying a resin in liquid form onto the insulating layer 10 by the spin-coating or the like, followed by being cured. The thickness of the resin film layer 60 is, for example, in the range of about 4 µm to about 100 µm. In the above case where the semi-cured resin film is laminated, it is pressed during laminating procedure so that a part of the resin film can be inserted into the clearance portion 50 between the source and drain electrodes, which leads to the interfitting of the part of the resin film layer with the clearance portion 50. As the resin film to be used for the lamination, a resin film preliminarily provided with a convex portion having a substantially complementary shape with respect to the clearance portion 50 may be used.

In a case where the adhesive material is applied to the laminating surface of a resin sheet, the resin sheet part may have a thickness in the range of about 2 µm to about 100 µm, and the adhesive material part may have a thickness in the range of about 3 µm to about 20 µm. The laminating condition may be appropriately selected depending on the curing properties of the resin film material and the adhesive material. For example, in a case where of the resin film composed of a polyimide film (thickness: about 12.5 µm) and an epoxy resin (thickness: about 10 µm) as the adhesive material applied to the laminating surface thereof, the resin film and the metal foil are laminated onto each other and the laminate thus formed is subject to a tentative pressure bonding under the heating condition of 60°C and the pressure condition of 3MPa. Thereafter, the adhesive material is subjected to a substantial curing at the condition of 140°C and 5MPa for 1 hour.

The resin film layer 60 thus formed serves to protect the semiconductor layer 20, and thereby a handling or conveying operation in the next step (e.g., patterning treatment of the metal foil 70) can be stably performed.

After the formation of the resin film layer 60, the supporting substrate 72 is removed from the film-laminated body 110. Thereafter, a gate electrode 12 is formed on the surface of the gate insulating film 10g. As a result, there can be finally obtained the flexible semiconductor device 100 according to the present invention.

When the removal of the supporting substrate 72 is performed with respect to the structure as shown in Fig. 3(c), the resin film 60 can serve as a supporting substrate instead thereof. As for the formation of the gate electrode 12, it can be formed from a metal paste (e.g., Ag paste). The formation of the gate electrode 12 can be performed through the application of the metal paste by a printing process such as a screen printing process, a gravure printing process and an ink jet process. Alternatively, the formation of the gate electrode 12 can be performed by thin film formation process (e.g., a vacuum deposition process, a sputtering process, or a plasma CVD process) or a plating process. Furthermore, in a case where the supporting substrate 72 is made of metal material (or electroconductive material), the gate electrode 12 can be formed by subjecting the supporting substrate to a patterning process.

A flexible semiconductor device in which the resin substrate is used as the supporting substrate has the laminated-body of the different materials (such as different materials of a thin-film transistor), and thus generally has a relatively small adhesive strength at the interface between the layers, which generally poses a problem for the adhesion of the layers. Particularly, the peeling phenomenon tends to occur at the interface between the metal layer and the organic material layer. In the conventional way, there is generally performed a formation of a layer consisting of a silane coupling agent having a high affinity with plastics on the surface of the metal, or an application of an epoxy resin having a lot of polar groups to the adhesive material to be used. This conventional way requires some combination of the specific materials, which can have little choice of the materials. Such limited kind of materials to be used makes the development of the device more difficult since all the conditions of the electrical properties, the heat resistance upon the production process and an environmental stability in a use environment are required to be met. The above problems of the adhesion/peeling become serious in the device with its greater area, considering that a warping occurs at the interface between different materials due to a mismatch of their thermal expansions in the laminated-body made of different materials, or considering that the larger an area of the laminated body becomes, the larger the warping becomes even in the case where the mismatch per unit length is the same. Such problems of the adhesion/peeling become more serious in the roll-to-roll process where the laminated-body is forced to be bent. In this regard, the problems of the peeling off (or detachment) are likely to occur at the interface where the adhesive strength is weak since the degrees of the warping are different between the upper layer and the lower layer in the laminated-body. The present invention can solve or alleviate the above problems, since the improved tight adhesiveness between "resin film layer 60" and "transistor structure including the source and drain electrodes 30s, 30d" is provided due to the fact that the protruding portion 65 of the resin film layer 60 interdigitates with the clearance portion 50 in the flexible semiconductor device 100 of the present invention.

To improve the adhesion between different materials by the interfitting structure (i.e., interdigitating structure), the size and the number of the protruding portion in the interdigitate structure are not particularly limited. However, the larger size the protruding portion has or the more number of the protruding portion the layer 60 has, the higher effect is provided. While on the other hand, when the interdigitate structure is separately and additionally formed in order to improve the adhesion, the areas for the formed transistors and wirings decrease, which can consequently bring disadvantages. In this regard, according to the present invention, there is no need to separately form the interdigitate structure for improving the adhesion since the channel area between the source/drain electrodes 30 (30s, 30d), which is located around the clearance portion 50, can serve as the interdigitate structure in the flexible semiconductor device 100. In other words, the larger size the protruding portion 65 has or the more number of the protruding portion 65 (i.e. the clearance portion 50) the interdigitate structure has, the higher effect of the adhesion/tight adhesiveness can be provided in the present invention. As for the size of the interdigitate structure in the present invention, the bottom face of the clearance portion is for example in the range of about 1 µm to about 1 mm, and the height thereof is for example in the range of about 0.5 µm to 100 µm when considering the size of the transistor structure. The surface density of the interdigitate structure can be decided in light of the resolution and the screen size in a case where it is used for an organic electroluminescence display device, for example. Just as an example, in a case where each of RGB pixels is equipped with two transistors in a television (or display) having 100 inches in size, the surface density of the interdigitate structure is about 580 per square inch in the NTSC system (having 720 by 480 pixels) and is about 3460 per square inch in the full high vision system (HD (high definition) system).

### 〈〈Embodiment of Present Invention wherein Source and Drain Electrodes with Clearance Portion are used as Mask〉〉

The bank member according to the present invention can be used as "mask member" for the formation of the electrodes. Specifically, the light irradiation can be performed by making use of, as the mask, the "source and drain electrodes between which the clearance portion 50 intervenes" obtained by the etching of the metal foil, so as to allow a part of a photocurable electroconductive paste layer to be cured to form the gate electrode. This is particularly advantageous in terms of the fact that the designing for the flexible semiconductor device generally requires consideration of the influence of the parasitic capacitance of the transistor wherein such parasitic capacitance is desired to be kept to the constant minimum. The specific explanation of the invention according to the mask embodiment will be now described below.

The manufacturing method of the flexible semiconductor device by making use of the bank member as "mask" is characterized in that it comprises the steps of:
(A)' providing a metal foil;
(B)' forming an insulating layer on the metal foil, the insulating layer having a portion serving as a gate insulating film;
(C)' etching away a part of the metal foil to form a source electrode and a drain electrode therefrom;
(D)' supply a photocurable electroconductive paste on a principal surface of the insulating layer, the principal surface being on the side opposite to another principal surface thereof on which a semiconductor layer is formed, and thereby forming a photocurable electroconductive paste layer from the paste; and
(E)' forming a gate electrode by making use of the source and drain electrodes as a mask wherein a light irradiation is performed from the provision side of the source and drain electrodes, and thereby allowing a part of the photocurable electroconductive paste layer to be cured.

One of features of the manufacturing method of the present invention according to the mask embodiment is that the light irradiation is performed by making use of the electrode obtained by the etching of the metal foil as the mask, and thereby allowing a part of the photocurable electroconductive paste layer to be cured to form another electrode. More specifically, the light irradiation is performed by making use of the source and drain electrodes obtained by the etching of the metal foil as the mask, and thereby allowing a part of the photocurable electroconductive paste layer provided on the side opposite to the provision of the semiconductor layer to be cured to form the gate electrode therefrom. This makes it possible to cause the end faces of the gate electrode to be coincident with the end face of the source electrode and the end face of the drain electrode. In other words, the source electrode and the gate electrode have such a positional relationship that one of end faces of the source electrode and one of end faces of the gate electrode are in alignment or matching with each other, and also the drain electrode and the gate electrode have such a positional relationship that one of end faces of the drain electrode and the other of end faces of the gate electrode are in alignment or matching with each other.

In the manufacturing method of the present invention according to the mask embodiment, after the step (C)', a semiconductor layer is formed on the another principal surface of the insulating layer to be accommodated in the clearance portion located between the source and drain electrodes. When the light irradiation of (E)' is performed after the formation of the semiconductor layer, such light irradiation is performed via the semiconductor layer. In other words, the irradiation of the light beam is performed toward the source and drain electrodes so that the irradiation light passes through the semiconductor layer located between the source and drain electrodes, and consequently the curing of the part of the photocurable electroconductive paste layer is performed by the passed light.

It is preferred that, upon the formation of the semiconductor layer, a raw material for the semiconductor layer is supplied to the clearance portion located between the source and drain electrodes by making use of the source and drain electrodes as the bank member.

In one preferred embodiment, prior to the step (C)', a supporting substrate is disposed on the insulating layer. Alternatively, a layer of such supporting substrate may be formed. In this embodiment, the supporting substrate is disposed or formed such that it is stacked on the insulating layer provided on the metal foil, and thereafter a part of the metal foil is etched away to form the source and drain electrodes form the metal foil.

Upon the formation of the source and drain electrodes, it is preferred that the metal foil is subjected to a photolithography process and a wet etching process to form inclined opposed end faces of the source and drain electrodes, between which the clearance portion intervenes. More specifically, an inclination of the end faces of the source and drain electrodes is formed so that the clearance portion has a tapered shape by the wet etching treatment.

The supporting substrate, which is disposed or formed on the insulating layer, may be made of ceramic material or metal material. In this case, the heating of the semiconductor layer and/or gate insulating film can be positively performed. As for the heating of the semiconductor layer, the semiconductor layer provided above the supporting substrate can be subjected to the heat treatment. It is preferred that the semiconductor layer (i.e., the semiconductor layer provided above the supporting substrate made of ceramic or metal) is subjected to an annealing treatment by irradiating it with a laser. This heating treatment can cause the modification of a film quality or property of the semiconductor layer, which leads to an achievement of the improved properties of the semiconductor layer. For example, the modification of the semiconductor layer makes it possible to improve the crystallinity of the semiconductor layer. As described above, the term *"anneal treatment"* used in the present description substantially means a heat treatment intended to improve or stabilize the properties such as "crystalline state", "degree of crystallization" and/or "mobility". As for the heating of the insulating layer, after the step (B)', the gate insulating film is subjected to the heating treatment. It is preferred that the gate insulating film (insulating layer) is subjected to an annealing treatment by irradiating it with a laser. Not only the gate insulating film may be directly subjected to the heat treatment (especially "annealing treatment"), but also the gate insulating film may be subjected to the heat treatment (especially "annealing treatment") by a heat from the semiconductor layer upon the heating treatment of the semiconductor layer.

The manufacturing method of the present invention according to the mask embodiment may further comprise the step for forming a resin film layer over the insulating layer such that the resin film layer covers the semiconductor layer, the source electrode and the drain electrode. The formation of the resin film layer can be performed by laminating a resin film over the insulating layer. Upon such formation of the resin film layer, a part of the resin film is forced to interfit with the clearance portion located between the source and drain electrodes. Just as an example, a resin film layer precursor is used, in which case the resin film layer precursor is laminated onto the supporting substrate equipped with the source and drain electrodes while being pressed so that a part of the resin film layer precursor is forced to be embedded into the clearance portion which is located between the source and drain electrodes and above the supporting substrate. Such formation of the resin film layer is performed by a roll-to-roll process.

In anther preferred embodiment regarding the manufacturing method of the present invention according to the mask embodiment, the insulating layer made of an inorganic material in which the gate insulating film is provided is formed in the step (B)'. For example, the insulating layer with the gate insulating film may be formed by a sol-gel process. Alternatively, the insulating layer with the gate insulating film may be formed by locally subjecting a valve metal of the metal foil to an anodic oxidation treatment.

The present invention according to the mask embodiment further provides a flexible semiconductor device obtained by the above manufacturing method. Such flexible semiconductor device comprises:
an insulating layer having a portion serving as a gate insulating film; and
a source electrode and a drain electrode provided on the insulating layer, the source and drain electrodes being formed of a metal foil
wherein a semiconductor layer is provided in a clearance portion between the source electrode and the drain electrode;
a gate electrode is provided on a principal surface of the insulating layer, the principal surface being on the side opposite to another principal surface on which the source and drain electrodes are provided; and
one of end faces (edges) of the source electrode and one of end faces (edges) of the gate electrode are in alignment with each other, and one of end faces (edges) of the drain electrode and the other of end faces (edges) of the gate electrode are in alignment with each other.

One of features of the flexible semiconductor device of the present invention according to the mask embodiment is that the end faces of the gate electrode are coincident with the end faces of the both source and drain electrodes such that they are self-aligned with each other.

The term *"coincident... such that they are self-aligned with each other"* as used in the present description substantially means the gate electrode and the source and drain electrodes are all formed in a self-aligned manner wherein the gate electrode has a desired positional relationship with respect to the source and drain electrodes, the positional relationship being attributed to the formation of such electrodes, not given by the special treatment regarding the formation of the electrodes. More specifically, in such a situation that the gate electrode and the source and drain electrodes are coincident in the self-aligned manner, one of end faces of the gate electrode is coincide with the end face of the source electrode in the direction of thickness of the flexible semiconductor device, whereas the other of end faces of the gate electrode is coincide with the end face of the drain electrode in the direction of thickness of the flexible semiconductor device.

In one preferred embodiment regarding the flexible semiconductor device of the present invention according to the mask embodiment, a contact point "A" between the insulating layer and the one of the end faces of the source electrode is opposed to a contact point "B" between the insulating layer and the one of the end faces of the gate electrode, and whereas a contact point "C" between the insulating layer and the one of the end faces of the drain electrode is opposed to a contact point "D" between the insulating layer and the other of the end faces of the gate electrode.

In the flexible semiconductor device of the present invention according to the mask embodiment, the clearance portion located between the source and drain electrodes preferably has a tapered shape wherein opposed end faces of the source and drain electrodes, between which the clearance portion intervenes, are inclined. More specifically, the end faces of the source and drain electrodes are inclined such that the clearance portion has the tapered shape.

The flexible semiconductor device of the present invention according to the mask embodiment is configured to dispose the resin film layer having flexibility over the insulating layer such that the semiconductor layer, the source electrode and the drain electrode are covered with the resin film layer. Such resin film layer is provided with a protruding portion which is interfitted with the clearance portion. More specifically, the protruding portion of the resin film layer is complementarily interfitted with the clearance portion. In other words, the protruding portion of the resin film layer and the clearance portion located between the source and drain electrodes have complementary form with respect to each other, and thereby the space of the clearance portion (i.e., clearance space other than the filled portion of the semiconductor layer in the clearance portion) is filled with the body of the protruding portion of the resin film layer.

The flexible semiconductor device of the present invention according to the mask embodiment may comprise a silicon or an oxide semiconductor (e.g., ZnO or InGaZnO).

In the flexible semiconductor device of the present invention according to the mask embodiment, the gate insulating film is made of an inorganic material. Preferably, the insulating layer with the gate insulating film may be one obtained by locally oxidizing the metal foil. In this case, the metal foil may comprise a valve metal material, and thus the insulating layer or gate insulating film may be an anodically-oxidized film of the valve metal material. In another embodiment, the insulating layer or gate insulating film may be an oxide film obtained from a sol-gel process.

According to the mask embodiment of the present invention, the further another manufacturing method of the present invention can be provided. Such further another manufacturing method of the present invention is also based on the feature that the light irradiation is performed by making use of the electrode obtained by the etching of the metal foil as the mask, so as to allow a part of the photocurable electroconductive paste layer to be cured to form another electrode. Such further another manufacturing method of the present invention comprises the steps of:
(A)" providing a metal foil;
(B)" forming an insulating layer on the metal foil, the insulating layer having a portion serving as a gate insulating film;
(C)" supply a photocurable electroconductive paste on a principal surface of the insulating layer, the principal surface being on the side opposite to another principal surface on which the gate electrode is to be formed, and thereby forming a photocurable electroconductive paste layer from the paste;
(D)" etching away a part of the metal foil to form a gate electrode therefrom; and
(E)" forming a source electrode and a drain electrode by making use of the gate electrode as a mask wherein a light irradiation is performed from the side of the gate electrode, and thereby allowing a part of the photocurable electroconductive paste layer to be cured.

In the above manufacturing method of the present invention according to the mask embodiment, the light irradiation is performed by making use of the gate electrode obtained by the etching of the metal foil as the mask, and thereby allowing a part of the photocurable electroconductive paste layer to be cured to form the source and drain electrodes. More specifically, the light irradiation is performed by making use of the gate electrode obtained by the etching of the metal foil as the mask, and thereby allowing a part of the photocurable electroconductive paste layer provided on the side opposite to the provision of the gate electrode to be cured to form the source and drain electrodes therefrom. This makes it possible to cause the end face of the source electrode and the end face of the drain electrode to be coincident with the end faces of the gate electrode.

The further another manufacturing method of the present invention has substantially the same embodiments as that of the manufacturing method of the present invention which utilizes the source and drain electrodes as the mask. For example, after the step (E)", a semiconductor layer is formed on the principal surface of the insulating layer to be accommodated in the clearance portion located between the source and drain electrodes. Such formation of the semiconductor layer can be performed by making use of the source and drain electrodes as the bank member. That is, a raw material for the semiconductor layer is supplied to the clearance portion located between the source and drain electrodes serving as the bank member. The further another manufacturing method of the present invention also may further comprises the step for forming a resin film layer over the insulating layer such that the resin film layer covers the semiconductor layer, the source electrode and the drain electrode. This formation of the resin film layer may be performed by laminating a resin film over the insulating layer. Upon such formation of the resin film layer, a part of the resin film is forced to interfit with the clearance portion located between the source and drain electrodes. Just as an example, a resin film layer precursor is used, in which case the resin film layer precursor is laminated over the supporting substrate equipped with the source and drain electrodes while being pressed so that a part of the resin film layer precursor is forced to be embedded into the clearance portion which is located between the source and drain electrodes and above the supporting substrate. Such formation of the resin film layer can be performed by a roll-to-roll process. Moreover, prior to the step (D)", a supporting substrate is disposed on the metal foil. Alternatively, a layer of such supporting substrate may be formed on the metal foil. In this case, the supporting substrate is disposed or formed such that it is stacked on the metal foil, and thereafter a part of the metal foil is etched away to form the gate electrode therefrom. The supporting substrate may be made of ceramic material or metal material. The heating (preferably "anneal heating") of the semiconductor layer and/or gate insulating film may be performed. In the step (B)" of the further another manufacturing method of the present invention according to the mask embodiment, the insulating layer made of an inorganic material in which the gate insulating film is provided may be formed in the step (B)". For example, the insulating layer with the gate insulating film may be formed by a sol-gel process. Alternatively, the insulating layer with the gate insulating film may be formed by locally subjecting a valve metal of the metal foil to an anodic oxidation treatment.

The flexible semiconductor device obtained by the further another manufacturing method of the present invention according to the mask embodiment has substantially the same embodiments as that of the above-mentioned flexible semiconductor device of the present invention, and thus is defined similarly. That is, the flexible semiconductor device obtained by the manufacturing method utilizing the gate electrode as the mask comprises
an insulating layer having a portion serving as a gate insulating film; and
a source electrode and a drain electrode provided on the insulating layer, the source and drain electrodes being formed of a metal foil
wherein a semiconductor layer is provided in a clearance portion between the source electrode and the drain electrode;
a gate electrode is provided on a principal surface of the insulating layer, the principal surface being on the side opposite to another principal surface on which the source and drain electrodes are provided; and
one of end faces of the source electrode and one of end faces of the gate electrode are in alignment with each other, and one of end faces of the drain electrode and the other of end faces of the gate electrode are in alignment with each other (more specifically, the source and drain electrodes are coincident with the gate electrode in the self-aligned manner).

The effect regarding the present invention according to the mask embodiment is "self-align effect". In this regard, according to the mask embodiment of the present invention, the electrode obtained by the etching of the metal foil is utilized as the mask for the formation of the another electrode during the light curing process, and thereby these electrodes can inevitably have a desired positional relationship with each other. In other words, "gate electrode" and "source / drain electrodes" spontaneously have the desired positional relationship with each other upon the formation thereof while being not given by the special treatment with respect to the formation of the electrodes. This means that a self-alignment of the electrodes of TFT is achieved. More specifically, one of end faces of the gate electrode is coincide with the end face of the source electrode in the direction of thickness of the flexible semiconductor device, whereas the other of end faces of the gate electrode is coincide with the end face of the drain electrode in the direction of thickness of the flexible semiconductor device. In other words, according to the mask embodiment of the present invention, the both end faces of the gate electrode are coincident with the end face of the source electrode and the end face of the drain electrode in the self-aligned manner, and consequently the flexible semiconductor device has a self-aligned gate structure. As a result, a constant and minimum parasitic capacitance of the transistor can be provided in the overlapping area between the gate electrode and the drain electrode.

In accordance with the mask embodiment of the present invention, not only the source and drain electrodes between which the clearance portion intervenes can be utilized as "bank member", but also they can be utilized as "mask". That is, the source and drain electrodes can be utilized to serve as "mask" as well as "bank member for the formation of the semiconductor layer". In this regard, such source and drain electrodes can be used directly as the electrodes of the TFT i.e., the constituent element of the flexible semiconductor device. This means that there is no need to finally remove or peel off the bank member which has contributed to the formation of the semiconductor layer, and also no need to finally remove or peel off the mask which has contributed to the formation of the electrode, and thereby the TFT element can be manufactured by simple and easy process, which leads to an achievement of the improved productivity thereof.

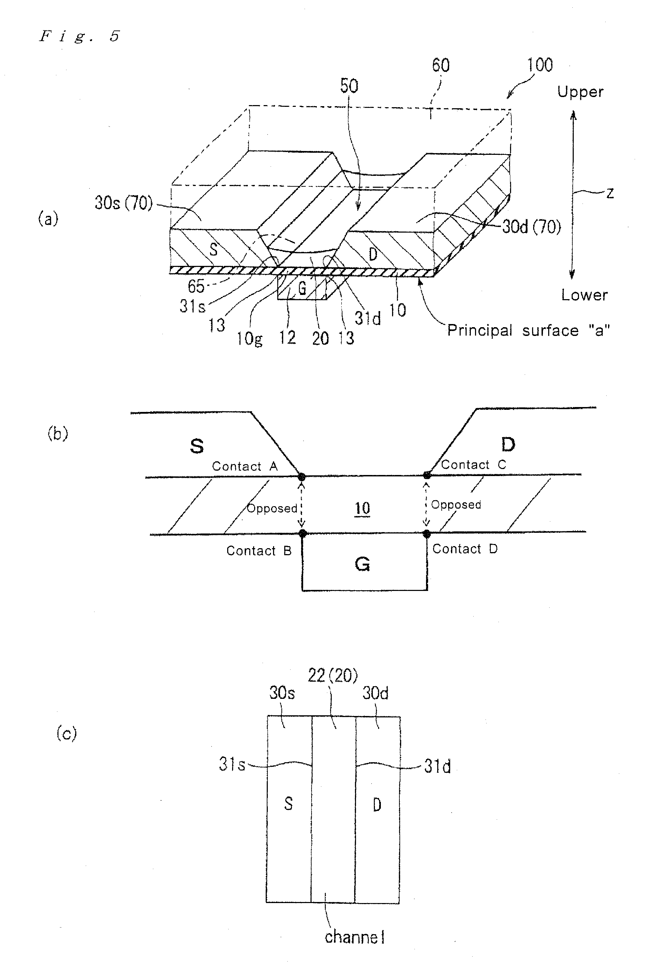

Now, with reference to Figs. 5(a) to 5(c), a flexible semiconductor device 100 according to the mask embodiment of the present invention will be explained. Fig. 5 (a) is a perspective view schematically illustrating the structure of the flexible semiconductor device 100 according to the mask embodiment of the present invention. Fig. 5(b) schematically shows "coincidence of self-alignment" characterized by the mask embodiment of the present invention. Fig. 5 (c) shows a relationship among a source 30s, a channel 22(20) and a drain 30d of the flexible semiconductor device 100.

The flexible semiconductor device 100 according to the mask embodiment of the present invention has flexibility. As shown in Fig 5(a), the flexible semiconductor device 100 comprises an insulating layer 10 having a portion serving as a gate insulating film 10g, and a source electrode 30s and a drain electrode 30d formed of a metal foil 70. The source electrode 30s and the drain electrode 30d are provided on the insulating layer 10.

Between the source electrode 30s and the drain electrode 30d, the clearance portion 50 is provided. According to the mask embodiment of the present invention, the source and drain electrodes 30s, 30d between which the clearance portion 50 intervenes serve as a mask member as well as the bank member. That is, the source and drain electrodes 30s, 30d between which the clearance portion 50 intervenes not only contribute to the positioning of the formed gate electrode, but also function as the positioning bank which determines the formed location of the semiconductor layer during the formation thereof.

As shown in Fig. 5(a), the semiconductor layer 20 is provided such that it occupies at least a part of the clearance portion 50. In Fig. 5(a), the shape of the clearance portion 50 is shown by illustrating the semiconductor layer 20 in a form of transparency.

In the flexible semiconductor device 100 according to the mask embodiment of the present invention, the gate electrode 12 is provided on a principal surface "a" of the insulating layer 10, the principal surface "a" being on the side opposite to another principal surface on which the source and drain electrodes 30s, 30d are provided. The end faces 13 of the gate electrode are coincident with the end face 31s of the source electrode 30s and the end face 31 d of the drain electrode 30d such that the end faces 13 of the gate electrode are self-aligned with the end faces 31s, 31 d of the source and drain electrodes. In other words, the flexible semiconductor device 100 according to the mask embodiment of the present invention is configured to have a self-aligned form between the gate electrode 12 and the source/drain electrodes 30s, 30d due to the gate electrode serving as "mask" during the light irradiation. This means that the flexible semiconductor device 100 according to the mask embodiment of the present invention has a self-aligned gate structure. Specifically, one 13 of end faces of the gate electrode 12 (i.e., source electrode 30s-sided end face 13 of the gate electrode) is coincide with the end face 31s of the source electrode 30s in the direction (Z) of thickness of the flexible semiconductor device, whereas the other 13 of end faces of the gate electrode (i.e., drain electrode 30d-sided end face 13 of the gate electrode) is coincide with the end face 31d of the drain electrode 30d in the direction (Z) of thickness of the flexible semiconductor device. More specifically, as shown in Fig. 5(b), a contact point "A" between the insulating layer 10 and the one of the end faces of the source electrode is opposed to a contact point "B" between the insulating layer 10 and the one of the end faces of the gate electrode, and whereas a contact point "C" between the insulating layer 10 and the one of the end faces of the drain electrode is opposed to a contact point "D" between the insulating layer 10 and the other of the end faces of the gate electrode.

A resin film layer 60 is formed over the insulating layer 10 such that the semiconductor layer 20, the source electrode 30s and the drain electrode 30d are covered with the resin film layer. In Fig. 5(a), the resin film layer 60 is shown by a dotted line (chain double-dashed line) so as to clearly show the clearance portion 50. As can be seen from the embodiment shown in Fig. 5(a), a part of the resin film layer 60 forms a protruding portion 65 (i.e., bulge portion) which is interfitted with the clearance portion 50. Particularly, the protruding portion 65 of the resin film layer 60 and the clearance portion 50 interdigitate or contact with each other to form a complementary form in the flexible semiconductor device 100 of the present invention. Thus, the interdigitate structure between the protruding portion 65 and the clearance portion 50 makes it possible to improve the tight adhesiveness between "resin film layer 60" and "structure including the source and drain electrodes 30s, 30d". In other words, the improved adhesion of the laminated structure in the flexible semiconductor device 100 is achieved due to the presence of the clearance portion 50.

The semiconductor layer 20 according to the mask embodiment of the present invention is obtained by allowing the clearance portion 50 to serve as the bank. For example, in a case where the formation of the semiconductor layer is performed at a clearance region in a thin film formation process or a printing process, the semiconductor material can deposit in the clearance portion 50 regardless of the any supply deviation of the raw material, and thereby the deposited material may be suitably utilized as the semiconductor layer. Therefore, the clearance portion 50 is capable of functioning as the positioning bank which determines the formed location of the semiconductor layer (see Fig. 4). For example, in a case where the semiconductor layer 20 made of silicon (Si) is formed, it be formed by supplying the liquid silicon into the clearance portion 50, in which case the clearance portion 50 also functions as a storage for the liquid silicon. In other words, in a case of the semiconductor raw material being in a liquid form or in a paste form, the clearance portion 50 can not only serve as the "positioning element" which functions to determine the positioning of the semiconductor raw material, but also serve as the "storage element" which functions to store (reserve) the supplied semiconductor raw material.

As a semiconductor material for the semiconductor layer 20 according to the mask embodiment of the present invention, the above-mentioned silicon (Si) may be used, but any other suitable materials may also be used. For example, the semiconductor layer may be made of the semiconductor material such as germanium (Ge), or an oxide semiconductor material. The oxide semiconductor may be an elementary oxide such as ZnO, SnO₂, In₂O₃ and TiO₂, or a composite oxide such as InGaZnO, InSnO, InZnO and ZnMgO. As needed, a compound semiconductor may also be used, in which case a compound thereof is for example GaN, SiC, ZnSe, CdS, GaAs and so forth. Furthermore, an organic semiconductor may also be used, in which case an organic compound thereof is for example pentacene, poly-3-hexyl-thiophene, porphyrin derivatives, copper phthalocyanine, C60 and so forth.

The insulating layer 10 having the gate insulating film 10g according to the mask embodiment of the present invention is made of inorganic materials in the flexible semiconductor device of the present invention. For example in a case of the semiconductor layer 20 made of silicon (Si), the gate insulating film 10g may be a silicon oxide film (SiO₂) or a silicon nitride film. The gate insulating film 10g can be formed by a sol-gel process. Alternatively, the gate insulating film 10g may be an oxide film formed by anodically oxidizing the metal foil 70.

The structure around the clearance portion 50 in the flexible semiconductor device according to the mask embodiment of the present invention, when seen from the above, can be illustrated as shown in Fig. 5 (c). The semiconductor layer 20 is provided on the gate insulating film 10g at the region of the clearance portion 50. The source electrode 30s and the drain electrode 30d are in contact with the semiconductor layer 20. At the lower surface of the semiconductor layer 20 (i.e., at the bottom surface of the semiconductor layer), there is provided the gate insulating film 10g and the gate electrode 12. Thus, a portion of the semiconductor layer 20, which is located between the source electrode 30s and the drain electrode 30d, can function as a channel region 22, which thus provides the device with a transistor (a thin-film transistor: TFT). According to the mask embodiment of the present invention, the end face 31s of the source electrode 30s and the end face 31d of the drain electrode 30d are in alignment with the end faces (not shown in Fig. 5(c)) of the gate electrode.

The resin film layer 60 according to the mask embodiment of the present invention is made of resin material which has flexibility. Particularly, the resin film layer 60, which can also serve as a supporting substrate for the transistor structure including the semiconductor layer 20, may be made of thermosetting resin materials or thermoplastic resin materials which provide the film layer with flexibility after being cured. Examples of such resin materials include, for example, an epoxy resin, a polyimide (PI) resin, an acrylic resin, a polyethylene terephthalate (PET) resin, a polyethylene naphthalate (PEN) resin, a polyphenylene sulfide (PPS) resin, polyphenylene ether (PPE) resin, a fluorinated resin (e.g., PTFE), a liquid crystal polymer, a composite thereof and the like. Alternatively, the resin film layer 60 may be made of an organic/inorganic-hybrid material which contains polysiloxane. The resin materials as described above are excellent in the dimensional stability and thus are preferably used as flexible materials of the flexible semiconductor device 100.

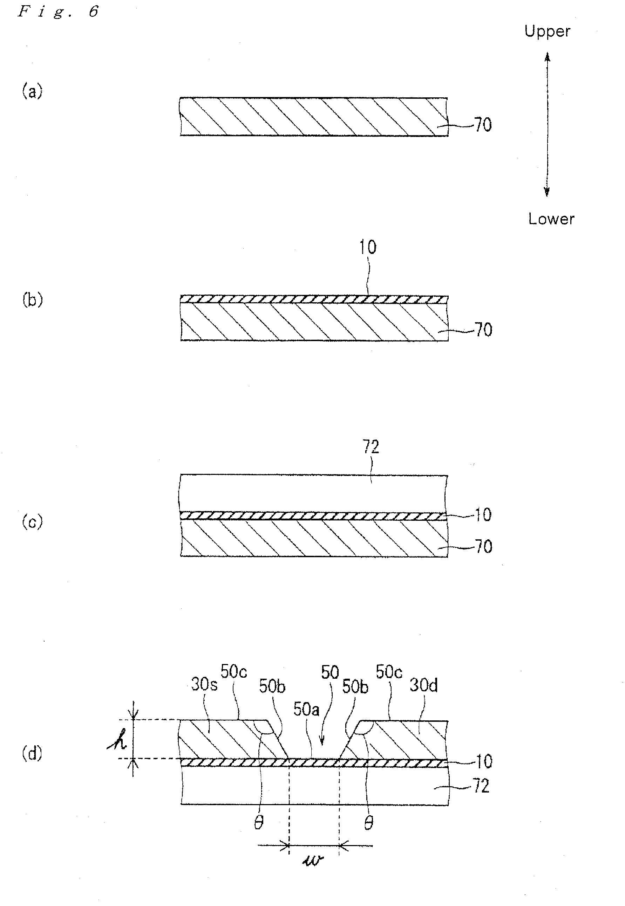

Next, with reference to Figs. 6(a) to 6(d), Figs. 7(a) to 7(c) and Figs. 8(a) to 8(b), the manufacturing method of the flexible semiconductor device 100 according to the mask embodiment of the present invention will be explained. Figs. 6(a) to 6(d), Figs. 7(a) to 7(c) and Figs. 8(a) to 8(b) respectively show cross-sectional views illustrating the steps in the manufacturing process of the flexible semiconductor device 100.

Upon carrying out the manufacturing method of the present invention, the step (A)' is firstly performed. That is, a metal foil 70 is provided as shown in Fig. 6(a). For example, the metal foil 70 according to the mask embodiment may be a copper foil or an aluminum foil. The metal foil 70 has a thickness in the range of about 0.5 µm to about 100 µm and preferably in the range of about 2 µm to about 20 µm, for example.

Subsequently, the step (B)' is performed wherein an insulating layer 10 is formed on the surface of the metal foil 70 as shown in Fig. 6(b). The thickness of the insulating layer 10 may be in the range of about 30 nm to about 2 µm. The insulating layer 10 includes a portion serving as a gate insulating film 10g. For example, the insulating layer 10 may be a silicon oxide layer. In such case, a thin film made of silicon oxide may be formed with using TEOS, for example.

The insulating layer 10 having the gate insulating film in a part thereof can be formed of an inorganic material. That is, even though an organic insulating film is generally used as the gate insulating film in the flexible semiconductor device wherein a resin substrate is used as a supporting substrate, the present invention makes it possible to use an inorganic insulating film as the gate insulating film, which leads to an improvement of the transistor performance of the flexible semiconductor device 100.

The reason for the improved performance of the transistor is that the gate insulating film made of the inorganic material not only has an improved dielectrics strength voltage even if being in a thin thickness, but also has a higher permittivity, compared with the case of the gate insulating film made of the organic material. According to the TFT structure of the present invention, the insulating layer 10 is provided over the surface of the metal foil 70, which makes it possible to lower the restriction in terms of the process for forming the insulating layer 10. This means that, the present invention enables the readily formation of the gate insulating film made of an inorganic material. Moreover, after the formation of the insulating layer 10 on the metal foil 70, the insulating layer 10 can be subjected to an annealing treatment (i.e., thermal annealing treatment) to improve the quality thereof, since the metal foil 70 is located beneath the insulating layer 10.

Moreover, in a case where the metal foil 70 is made of aluminum, the insulating layer 10 can be formed by locally and anodically oxidizing the surface region of the metal foil 70. The insulating layer formed by the locally anodic oxidation may have the thickness in the range of about 30 nm to about 200 nm. Any suitable chemical conversion solutions can be used for the anodic oxidation of the aluminum, and thereby a dense and very thin oxidized film can be formed. For example, as the chemical conversion solution, a "mixed solution of aqueous tartaric acid solution and ethylene glycol" with an adjusted pH of around the neutral value by using of ammonia, may be used. The metal foil 70 from which the insulating layer 10 can be formed by the anodic oxidation is not only aluminum foil, but also any suitable metal foil which has a good electric conductivity and is capable of readily forming a dense oxide. For example, the metal foil 70 may be made of a valve metal. Examples of the valve metal include, but not limited to, at least one metal selected from the group consisting of aluminum, tantalum, niobium, titanium, hafnium, zirconium, molybdenum and tungsten, or an alloy thereof. In a case where the anodic oxidation is adopted, there can be provided an advantage in that an oxide film with an even thickness can be formed on the surface even when the surface of the metal foil 70 has a complicated form. Also, in the case of the anodic oxidation, there can be provided another advantage in that a gate insulating film with a higher permittivity can be formed, compared with that of a silicon oxide film.

Moreover, the material of the metal foil 70 is not limited to the valve metal material (e.g., aluminum material), but the metals of the foil may be those capable of giving an oxide film which is uniformly coated on the surface of the foil by an oxidation. Therefore, a metal other than the valve metal may be used. In this regard, the oxidation process of the metal foil 70 can be performed by a thermal oxidation (surface oxidation by heating treatment) or chemical oxidation (surface oxidation by an oxidizing agent) instead of the anodic oxidation.

Alternatively, the insulating layer 10 can be formed by performing a sol-gel process. The insulating layer formed by the sol-gel process may have the thickness in the range of about 100 nm to about 1 µm. In this case, the insulating layer 10 may be a silicon oxide film, for example. Just as example of the case of the sol-gel process for forming the silicon oxide, it can be formed by evenly applying a colloidal solution (a sol-liquid), which has been prepared by stirring a mixture solution of tetraethoxysillane (TEOS), methyltriethoxysilane (MTES), ethanol and dilute hydrochloric acid (0.1 wt %) for 2 hours at room temperature, onto the metal foil by a spin-coating process and then is subjected to a heat treatment at 300°C for 15 minutes. According to such sol-gel process, there is provided an advantage in that it can produce a gate insulating film with a high permittivity (e.g., such as the silicon oxide film, a hafnium oxide film, an aluminum oxide film and a titanium oxide film with a high permittivity).

Subsequent to the formation of the insulating layer, a supporting substrate 72 is formed on the insulating layer 10 as shown in Fig. 6(c). The supporting substrate 72 may be a ceramic substrate (e.g., substrate made of alumina (Al₂O₃), zirconia (ZrO)) or metal substrate (e.g., substrate made of stainless steel such as SUS304). Alternatively, a resin substrate may be used as the supporting substrate 72. For example, such ceramic or resin substrate may be laminated onto the insulating layer 10 (optionally with the use of an adhesive) so that the formation of the supporting substrate 72 on the insulating layer 10 can be suitably performed.

Subsequently, a part of the metal foil 70 is removed by subjecting the metal foil 70 to an etching treatment, and thereby a source electrode 30s and a drain electrode 30d are formed from the metal foil 70 as shown in Fig. 6(d). That is, the step (C)' in the manufacturing method of the present invention according to the mask embodiment is performed. Even when the etching of the metal foil 70 is performed, all of the source and drain electrodes and the insulating layer 10 are suitably held together by the supporting substrate 72 provided on one side of the insulating layer 10. In other words, all of them are prevented from splitting into pieces in spite of the etching of the metal foil 70.

The formation of the source and drain electrode 30s, 30d can be performed by a combination of a photolithography process and an etching process, for example. More detailed explanation about this is as follows: First, a photoresist film is formed on the whole surface of the metal foil 70 by using of photoresist materials such as a dry film or liquid type one. Then, by using of a photomask having desired shape and position corresponding to the source and drain electrodes 30s,30d, the photoresist film is subjected to a pattern-exposure process, followed by a development process. Subsequently, by making use of the resulting photoresist film having the desired pattern of the source and drain electrodes 30s,30d as a mask, the metal foil 70 is immersed in an etching solution, and thereby the source electrode 30s and the drain electrode 30d as well as the clearance portion 50 which intervenes therebetween are formed. Finally, by removing the photoresist film, there can be obtained "source and drain electrodes between which the clearance portion intervenes". For example, the etching solution may be suitably selected depending on the kind of the metal foil. Just as an example, a solution of ferric chloride, or a solution of sulfuric acid and hydrogen peroxide may be used in a case where of a copper foil. In another case of an aluminum foil, a mixed solution of phosphoric acid, acetic acid and nitric acid may be used.

According to the mask embodiment of the present invention, opposed end faces 50b of the source and drain electrodes 30s,30d, between which the clearance portion 50 intervenes, are inclined. In other words, as shown in Fig. 6(d), the surrounding portion of the clearance portion 50 is composed of a bottom face 50a, wall faces 50b and top faces 50c wherein the wall faces are inclined ones. The angle θ between the wall face 50b and the top face 50c is an obtuse angle. For example, the angle θ is in the range of about 100 degrees to about 170 degrees, preferably in the range of about 110 degrees to about 160 degrees (see Fig. 6(d)). The bottom width "w" of the clearance portion 50 as shown in Fig. 6(d) is preferably in the range of about 1 µm to about 1 mm, more preferably in the range of about 10 µm to about 300 µm. The depth (or height) "h" of the clearance portion 50 as shown in Fig. 6(d) is preferably in the range of about 0.5 µm to about 100 µm, more preferably in the range of about 2 µm to about 20 µm.

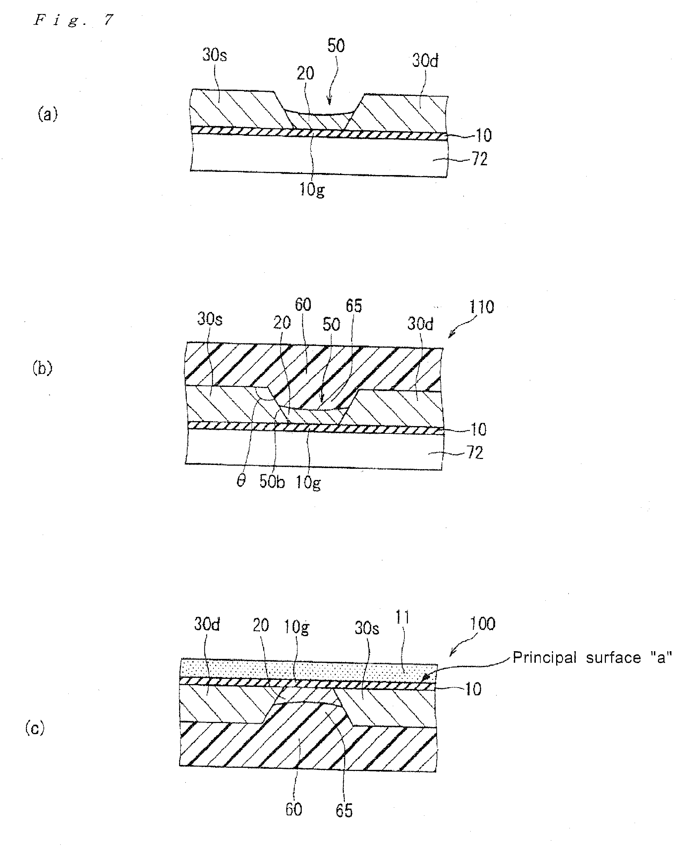

Subsequent to the formation of the source and drain electrodes, as shown in Fig. 7(a), a semiconductor layer 20 is formed in the clearance portion 50 by making use of the source and drain electrodes 30s, 30d as the bank member. The formed semiconductor layer 20 may have a thickness in the range of about 30 nm to about 1 µm, preferably in the range of about 50 nm to about 300 nm. In this formation, the semiconductor layer 20 can be suitably formed since the source and drain electrodes 30s, 30d between which the clearance portion 50 intervenes can function as the bank member for determining the position of the raw material of the semiconductor layer.

Specifically, the semiconductor layer 20 is formed on a part of the insulating layer 10 (especially, on a gate insulating film 10g thereof), the part corresponding to the surrounding bottom face 50a of the clearance portion 50. In other words, the semiconductor layer 20 is formed to be accommodated in the clearance portion 50.

For example in a case where the semiconductor layer is formed by a thin film formation process or a printing process, the deposition of the semiconductor materials can be performed in the clearance portion 50, and thereby such deposited materials may be suitably utilized as the semiconductor layer. In this case, the clearance portion 50 can serve to determine the positioning of the semiconductor layer formation (see Fig. 4). In other words, "source and drain electrodes between which the clearance portion 50 intervenes" serves as the bank member for the "positioning" of the semiconductor layer. Examples of the thin film formation process include, but not limited to, a vacuum deposition process, a sputtering process, a plasma CVD process and the like. While on the other hand, examples of the printing process include a relief printing process, a gravure printing process, a screen printing process, an ink jet process and the like.

In a case where the raw material for the semiconductor layer 20 is in a liquid form and thus it is supplied to the bottom face 50a, the supplied raw material can be held in the clearance portion 50 while preventing the material from flowing out of the clearance portion 50. That is, in the case where the raw material for the semiconductor layer is in a liquid form or in a paste form, the "source and drain electrodes between which the clearance portion 50 intervenes" serves as the bank member for the "storing" of the raw material in addition to the "positioning" of the semiconductor layer.

The formation of the semiconductor layer will be now specifically explained. In a case where the semiconductor layer 20 is formed as a silicon layer, a solution material containing a cyclic silane compound (e.g., a toluene solution of cyclopentasilane) for example is applied over the bottom face 50a of the clearance portion 50 by an ink jet process or the like. Subsequently, the applied material is subjected to a heat treatment at a temperature of 300°C, and thereby the semiconductor layer 20 made of amorphous silicon is formed.

At a point in time immediately after the formation of the semiconductor layer 20, it is in a situation where the semiconductor layer 20 is located above the metal foil 70 via the insulating layer 10. Thus, the layer 20 can be subjected to an annealing treatment. Such annealing treatment of the semiconductor layer 20 makes it possible to improve or modify a film quality of the semiconductor layer 20. Particularly in a case where the supporting substrate 72 is made of a ceramic or metal, the annealing treatment at a high temperature causes substantially no problem, since such substrate has a superior heat resistance property. Even in a case where the supporting substrate 72 is formed of a resin material, the annealing of the semiconductor layer 20 can be performed since it can still have a supporting function upon the annealing treatment thereof, in which case, although the deteriorated film quality of the supporting substrate 72 may be caused by the annealing treatment, such supporting substrate 72 is finally removed, and thereby posing no obstacle to the performance of the annealing treatment.

In a case where the semiconductor layer 20 made of the amorphous silicon is formed in the clearance portion 50, it can be modified to a polycrystalline silicon (for example, the polycrystalline silicon having its average particle diameter of a few hundred nm to about 2 micrometers) by the annealing treatment. In another case of the semiconductor layer 20 made of a polycrystalline silicon, the degree of the crystallization thereof can be improved by the annealing treatment. Moreover, the modification of the film quality of the semiconductor layer 20 can lead to an improved mobility of the semiconductor layer 20. This means that there may be a significant difference in the mobility of the semiconductor layer 20 between the before-annealing and the after-annealing.

In this regard, a brief explanation regarding the relationship between the crystal particle diameter of the silicon semiconductor and the mobility is as follows, for example:
The mobility of a-Si (amorphous silicon) is less than 1.0 cm²/Vs. The mobility of µC-Si (microcrystalline silicon) is about 3 (cm²/Vs), and the crystal particle diameter thereof is in the range of 10 nm to 20 nm. The mobility of pC-Si (polycrystalline silicon) is about 100 (cm²/Vs) or in the range of about 10 to about 300 (cm²/Vs), and the crystal particle diameter thereof is in the range of about 50 nm to about 0.2 µm. Therefore, when the film quality is modified due to the annealing treatment from a-Si (amorphous silicon) to µC-Si (microcrystal silicon) or pC-Si (polycrystalline silicon), the mobility can increase by more than several times (i.e., several times, tens times, hundreds times and so on). Incidentally, the mobility of sC-Si (single crystal silicon) is about 600 (cm²/Vs) or more.

As the annealing treatment of the semiconductor layer, the metal foil 70 provided with the semiconductor layers 20 can be subjected to a heat treatment as a whole. Alternatively, by irradiating the clearance portion 50 with the laser light, the semiconductor layer 20 can be subjected to a heat treatment. In a case of the annealing treatment by the laser irradiation, the following procedure may be adopted for example: The semiconductor layer may be irradiated with an excimer laser (XeCl) having a wave length of 308 nm, 100 shots to 200 shots with an energy-density of 50 mJ/cm² and a pulse width of 30 nanoseconds. It should be noted that the specific conditions of the annealing treatment are suitably selected in light of the various factors.

The heat treatment of the insulating layer 10 (especially, gate insulating film 10g) can be simultaneously performed upon the heat treatment of the semiconductor layer 20. In other words, the anneal treatment of the semiconductor layer 20 and the anneal treatment of the insulating layer 10 may be simultaneously performed in the same process. The anneal treatment of the semiconductor layer 20 makes it possible to modify the film quality of the insulating layer 10 (especially gate insulating film 10g). In this regard, when the semiconductor layer is heated, the gate insulating film 10 may also be heated due to the heat thereof. In a case where the insulating layer 10 is an oxide film (SiO₂) prepared by a thermal oxidation (wet oxidation) in the steam, the electron trap level of the oxide film (SiO₂) can be reduced by heating of the insulating layer 10. Further explained in this regard, the wet oxidation is preferable since the productivity is superior due to an oxidizing velocity being about 10 times as high as that of the dry oxidation. But, the wet oxidation has a tendency that the electron trap level increases. While on the other hand, the dry oxidation has so much hole traps, in spite that the generation of the electronic trap level is lowered. Accordingly, a gate oxide film having fewer electron traps and fewer hole traps can be produced with sufficient productivity by performing, under an oxygen atmosphere, the heat treatment of the oxide film produced by the wet oxidation.

Subsequent to the formation of the semiconductor layer 20 (and the heating treatment thereof), a resin film layer 60 is formed. Specifically, as shown in Fig. 7(b), the resin film layer 60 having translucency (e.g., the resin film layer with the ultraviolet transmitting capability) is formed such that it covers the source electrode 30s, the drain electrode 30d and the semiconductor layer 20. As a result, a film-laminated structure (flexible substrate structure) 110 is obtained. According to the present invention, a part of the resin film layer 60 is forced to be inserted into the clearance portion 50 upon the formation of the resin film layer 60. That is, the formation of the resin film layer 60 is performed so that the inside of the clearance portion 50 is filled with the material body of the resin film. This means that the resin film layer 60 is provided to have the protruding portion 65 which interdigitates with the clearance portion 50. Such interdigitate structure between the protruding portion 65 and the clearance portion 50 can improve the tight adhesiveness between "resin film layer 60" and "transistor structure including the source and drain electrodes 30s, 30d".

The angle θ (see Fig. 6(d)) regarding the opposed faces defining the clearance portion 50 is an obtuse angle according to the present invention, and thereby the insertion of a part of the resin film 60 into the clearance portion 50 is facilitated as compared with the case where the angle θ is a right angle. This is desirable since the formation of the interfitting (interdigitating) between the protruding portion 65 and the clearance portion 50 can be promoted. In the case where the angle θ is an obtuse angle, the function of the source and drain electrodes 30d, 30d as the bank member upon the formation of the semiconductor layer 20 may be further improved compared with the case where the angle θ is a right angle. Specifically, even when the positional precision of the supply device is inferior (or the supply device has significant tolerance) in terms of the supplying of the semiconductor materials into the clearance portion 50, the structure where the angle θ is an obtuse angle can improve such positional precision of the formed semiconductor layer 20. The reason for this is that the region for receiving the supplied material can be enlarged due to the presence of the clearance portion wherein the angle θ is an obtuse.

Examples of the formation process for the resin film layer 60 include, but not limited to, a process of laminating a semi-cured resin film onto the insulating layer 10, followed by being cured (wherein an adhesive material may be applied to a laminating surface of the resin sheet), and a process of applying a resin in liquid form onto the insulating layer 10 by the spin-coating or the like, followed by being cured. The thickness of the resin film layer 60 is, for example, in the range of about 4 µm to about 100 µm. In the above case where the semi-cured resin film is laminated, it is pressed during laminating procedure so that a part of the resin film can be inserted into the clearance portion 50 between the source and drain electrodes, which leads to the interfitting of the part of the resin film layer with the clearance portion 50. As the resin film to be used for the lamination, a resin film preliminarily provided with a convex portion having a substantially complementary shape with respect to the clearance portion 50 may be used.

In a case where the adhesive material is applied to the laminating surface of a resin sheet, the resin sheet part may have a thickness in the range of about 2 µm to about 100 µm, and the adhesive material part may have a thickness in the range of about 3 µm to about 20 µm. The laminating condition may be appropriately selected depending on the curing properties of the resin film material and the adhesive material. For example, in a case where of the resin film composed of a polyimide film (thickness: about 12.5 µm) and an epoxy resin (thickness: about 10 µm) as the adhesive material applied to the laminating surface thereof, the resin film and the metal foil are laminated onto each other and the laminate thus formed is subject to a tentative pressure bonding under the heating condition of 60°C and the pressure condition of 3MPa. Thereafter, the adhesive material is subjected to a substantial curing at the condition of 140°C and 5MPa for 1 hour.

The resin film layer 60 thus formed serves to protect the semiconductor layer 20, and thereby a handling or conveying operation in the next step (e.g., patterning treatment of the metal foil 70) can be stably performed.

After the formation of the resin film layer 60, the supporting substrate 72 is removed from the film-laminated body 110. When the removing of the supporting substrate 72 is performed with respect to the structure as shown in Fig. 7(b), the resin film 60 can serve as a supporting substrate instead thereof.

Subsequent to the removal of the supporting substrate 72, the step (D)' in the manufacturing method of the present invention according to the mask embodiment is performed. That is, as shown in Fig. 7(c), a photocurable electroconductive paste is applied on the insulating layer 10 having the gate insulating film 10g is to form a layer 11 of the photocurable electroconductive paste. More specifically, a light curable electroconductive paste is supplied to a principal surface "a" of the insulating layer 10 to form the photocurable electroconductive paste layer, the principal surface "a" being on the side opposite to another principal surface thereof on which a semiconductor layer 20 is formed. The photocurable electroconductive paste layer 11 may have a thickness in the range of about 50 nm to about 20 µm. As the electroconductive paste, the conventional photocurable electroconductive paste may be used. For example, ultraviolet curable paste material (e.g., Ag paste) may be used. As for the Ag paste, it may comprise Ag particles having a particle size of about 10 nm to about 20 µm, a resin capable of initiating photopolymerization (e.g., an epoxy acrylate resin) and a solvent for controlling the viscosity (e.g., ethyl cellulose (EC)). The application of the electroconductive paste can be performed, for example, by performing a printing process to put the paste over the entire surface of the insulating layer 10. Examples of the printing process include a screen printing, a gravure printing, an ink jet method and the like. By such printing process, the paste can be supplied onto the insulating layer around the gate insulating film 10g to form the photocurable electroconductive paste layer 11.

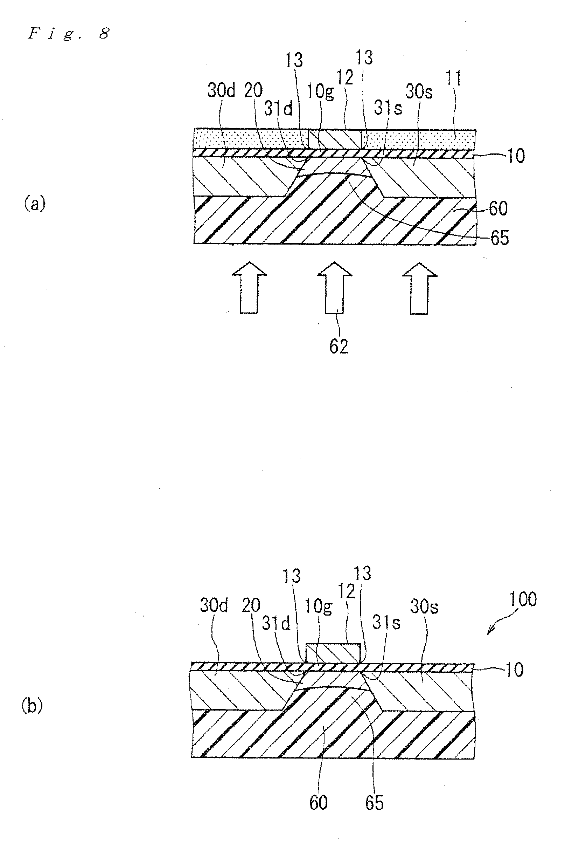

Subsequent to the formation of the layer 11, as shown in Fig. 8(a), a light irradiation with a light beam 62 (for example, UV light) is performed from the side of the resin film layer 60 (i.e., from the back side of the structured substrate shown in Fig. 8(a)). That is, the step (E)' in the manufacturing method of the present invention according to the mask embodiment is performed. Specifically, as shown in Fig. 8(a), the light irradiation is performed from the side of the source electrode 30s and the drain electrode 30d by utilizing the source and drain electrode 30s,30d as the mask. The light 62 for the irradiation transmits through the resin film layer 60 and passes through the clearance portion between the source electrode 30s and the drain electrode 30d, which allows a part of the electroconductive paste layer 11 to be cured, the part being next to the channel area. The curing of the part of the electroconductive paste layer forms the gate electrode 12 therefrom. As the light beam for the irradiation, a light beam having a wavelength capable of transmitting through the resin film layer 60, the gate insulating film 10 and the semiconductor layer 20 and also capable of curing the electroconductive paste layer 11 may be used. The wavelength of the light beam may be selected to enable the light beam to transmit through the resin film layer, the gate insulating film and the semiconductor layer and also enable the curing of the electroconductive paste. For example, in a case where the resin film layer 60 is made of an acrylate resin (PMMA) or a polycarbonate (PC), the gate insulating film is made of a silicon oxide, and the semiconductor layer 20 is made of InGaZnO, a light beam having the wavelength of about 436 nm (so-called "g-ray light") is capable of transmitting therethrough and also is capable of the curing of the photocurable electroconductive paste layer 11.

In this step of the light irradiation, the curing of a part of the electroconductive paste layer 11 can be performed by making use of the source electrode 30s and the drain electrode 30d as the mask, and thereby enabling the one end face 13 of the formed gate electrode 12 to be in alignment with the end face 31s of the source electrode 30s, and also enabling the other end face 13 of the formed gate electrode 12 to be in alignment with the end face 31d of the drain electrode 30d. This means that a self-aligned gate structure can be provided by this step of the light irradiation.

As describe above, the end face 13 of the gate electrode 12 is formed to coincide with the end faces (31s/31d) of the source/drain electrodes in a self-aligned manner by making use of the source electrode and the drain electrode as the mask upon the light irradiation with a light beam 62. In this regard, in light of an actual production process, heat generated by the irradiation of the light beam 62 may cause the curing region to expand to somewhat extent, so that it may arise that the end face 13 of the gate electrode 12 fails to exactly coincide with the end faces (31s/31d) of the source/drain electrodes. It is, however, assumed in the present invention that the above end faces shall be formed to self-align (i.e. self-alignedly formed) with each other with a view to the above somewhat expansion in the actual production process. Moreover, it may arise that the light beam 62 may be diffracted or scattered by the source/drain electrodes serving as the mask for the gate electrode 12, and thereby causing the curing region of the electroconductive paste layer 11 to change to somewhat extent, which may lead to a misalignment of the end face 13 of the gate electrode with the end faces (31s/31d) of the source/drain electrodes. However, it is also assumed in the present invention that the above end faces shall be formed to self-align (i.e. self-alignedly formed) with each other with a view to the above somewhat misalignment in the actual production process.

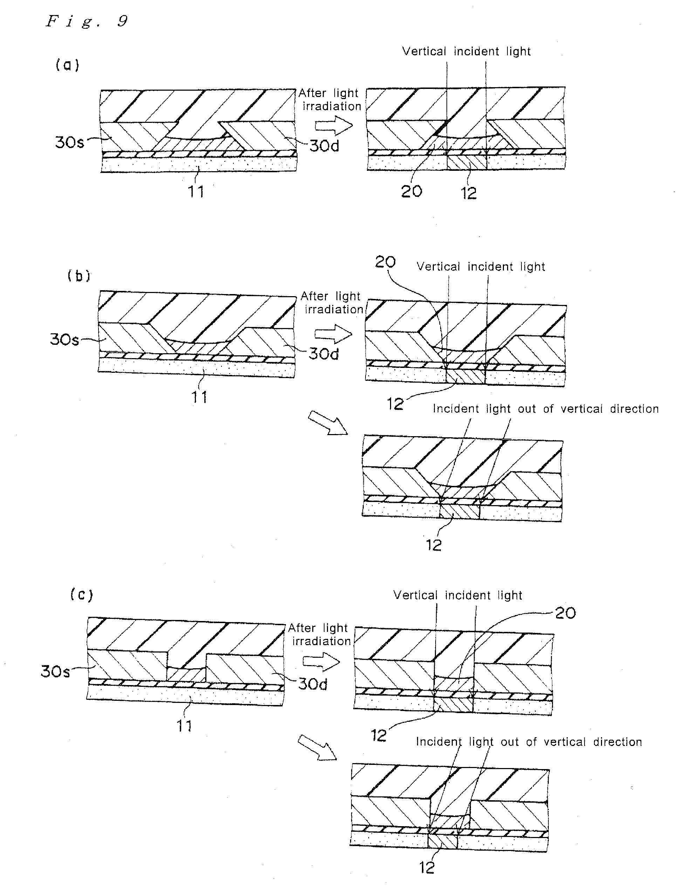

According to the mask embodiment, an advantage effect is provided during the light irradiation of the step (E)' due to the fact that the opposed end faces of the source and drain electrodes between which the clearance portion intervenes are inclined. In this regard, the present invention particularly has a forward-type tapered shape wherein the width of the clearance portion is wider towards the light source, which can provide the following advantageous effects. For example in a case where the "clearance portion" has a reverse-type tapered shape (i.e., the width of the clearance portion is narrower towards the light source as shown in Fig. 9(a), the formed area of the gate electrode becomes smaller than that of the semiconductor layer 20 upon the perpendicular entering of the exposing light. This causes an adverse effect in that the channel region (which is formed at the area corresponding to the gate electrode) fails to lie all over the semiconductor layer 20, which results in an increase of the resistance between the source electrode and the drain electrode upon the activation of the transistor. While on the other hand, in a case where the clearance portion has the forward-type tapered shape according to the present invention (see Fig. 9(b)), the above adverse effect is not caused, and thus the formed area of the gate electrode 12 corresponds to that of the semiconductor layer 20. This may be achieved also in the case of no tapered shape of the clearance portion (see Fig. 9(c)). However, supposing that the exposing light enters slightly out of the vertical direction of the structured substrate in the case of no tapered shape of the clearance portion, the adverse effect is caused in that the formed area of the gate electrode becomes smaller than that of the semiconductor layer 20 since a part of the light is blocked due to the presence of the source and drain electrodes (see Fig. 9(c)). While on the other hand, in the case of the tapered shape of the clearance portion, such adverse effect is not caused since the exposing light is not adversely blocked even when the exposing light enters slightly out of the vertical direction, which leads to the corresponding of the formed area of the gate electrode 12 to that of the semiconductor layer 20 (see Fig. 9(b)). Accordingly, the skilled person in the art can understand that the "clearance portion" having the forward-type tapered shape according to the present invention proivdes the advantageous effects during the light irradiation of the step (E)'.

Subsequent to the light irradiation, the uncured portion of the electroconductive paste layer 11 is removed as shown in Fig. 8(b). As a result, there can be obtained the flexible semiconductor device 100 according to the mask embodiment of the present invention. As for the flexible semiconductor device 100 according to the mask embodiment, another resin film layer (not shown) may be formed over the insulating layer 10 to cover the gate electrode 12.

In accordance of the mask embodiment of the present invention, the formation of the gate electrode 12 can be performed by utilizing the source electrode 30s and the drain electrode 30d as the mask so that the electroconductive paste layer 11 is allowed to be partially cured. Therefore, the mutual positional relationship among the gate electrode 12, the source electrode 30s and the drain electrode 30d can be automatically provided without performing the mask alignment which tends to cause errors. The self-aligned gate structure according to the present invention makes it possible to minimize the overlapped region of the three electrodes and also keep it constant. As a result, the parasitic capacitance of the transistor, which may be generated at the overlapped region between the gate electrode 12 and drain electrode 30d, can be kept to the constant minimum. Therefore, the mask embodiment of the present invention can improve the characteristics of image quality and its uniformity as well as the reliability. In this regard, the larger the area of the device becomes, the harder the mask alignment becomes, which will lead to an increased need for the self-aligned gate structure.

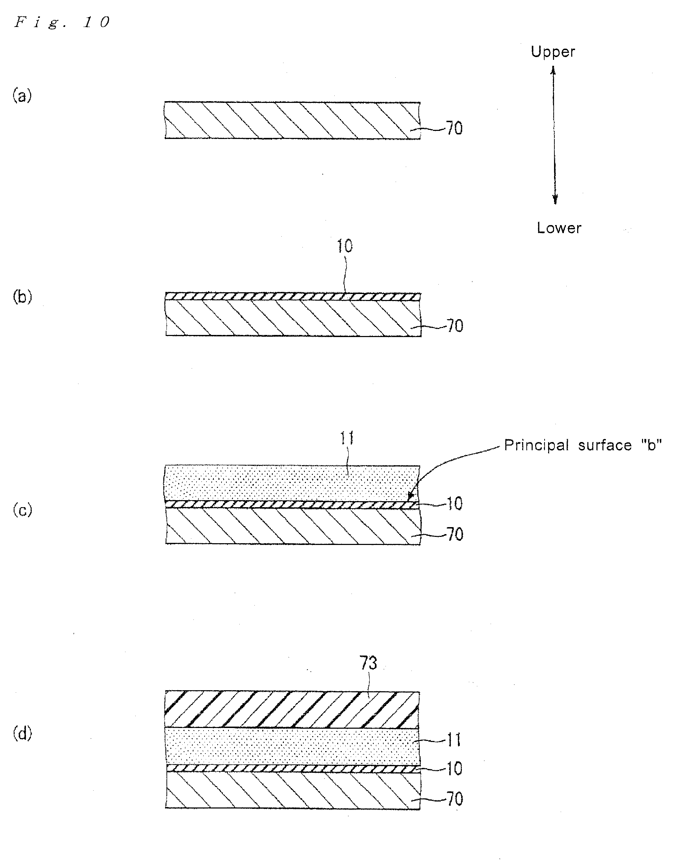

While the above manufacturing method of the present invention according to the mask embodiment forms the gate electrode in a self-aligned manner by utilizing the source and drain electrodes as the mask. However, the inverse embodiment is also possible. That is, the gate electrode can be utilized as the mask to form the source and drain electrodes in a self-aligned manner. Such manufacturing method of the present invention according to the mask embodiment will now be described below with reference to Figs. 10(a) to 10(d), Figs. 11(a) to 11(c) and Figs. 12(a) to 12(b). Figs. 10(a) to 10(d), Figs. 11(a) to 11(c) and Figs. 12(a) to 12(b) are respectively show cross-sectional views illustrating the steps in the manufacturing process of the flexible semiconductor device 100'.

First, as shown in Fig. 10(a), a metal foil 70 is provided. That is, the step (A)" in the manufacturing method of the present invention according to the mask embodiment is performed. For example, the metal foil 70 may be a copper foil or an aluminum foil. Then, as the step (B)", an insulating layer 10 is formed on the surface of the metal foil 70 as shown in Fig. 10(b). The insulating layer 10 has a portion serving as a gate insulating film 10g.

Subsequent to the formation of the insulating layer 10, a photocurable electroconductive paste is applied on the insulating layer 10 to form a photocurable electroconductive paste layer 11 as shown in Fig. 10(c). That is, the step (C)" in the manufacturing method of the present invention according to the mask embodiment is performed. Specifically, the light curable electroconductive paste is supplied to a principal surface "b" of the insulating layer 10 to form the photocurable electroconductive paste layer 11, the principal surface "b" being on the side opposite to another principal surface thereof on which a gate electrode is to be formed. Thereafter, a supporting substrate 73 is formed on the electroconductive paste layer 11 as shown in Fig. 10(d). The supporting substrate 73 may be, for example, one made of a resin material. However, a ceramic substrate or a metal substrate may also be used as the supporting substrate 73.

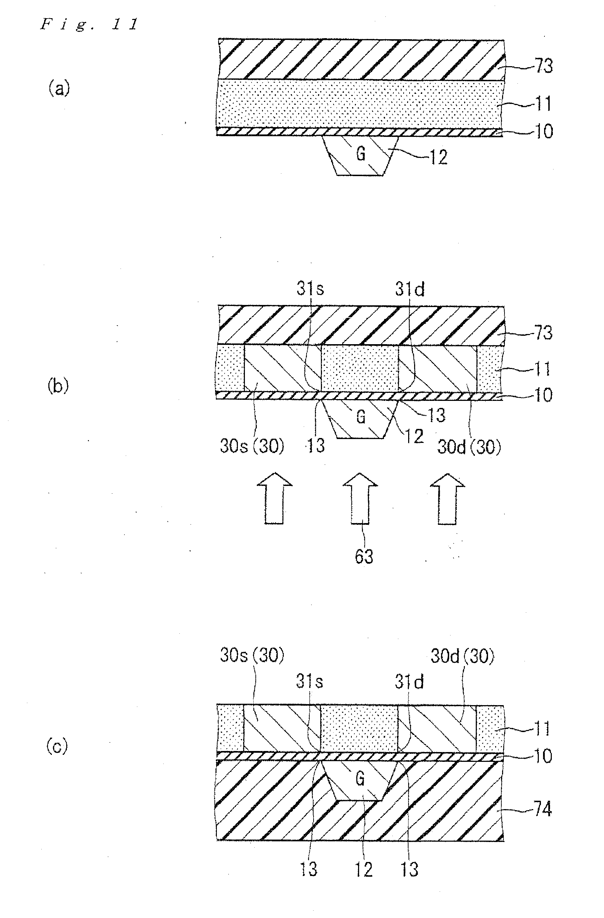

Subsequent to the formation of the supporting substrate, the step (D)" is performed wherein the gate electrode 12 is formed by etching away a part of the metal foil 70 as shown in Fig. 11 (a). Specifically, the gate electrode 12 is formed by subjecting the metal foil 70 to a photolithography process and a wet etching process. Thereafter, as shown in Fig. 11 (b), the light irradiation 63 (e.g., irradiation with UV light) is performed from the side of the gate electrode. That is, the step (E)" is performed. More specifically, the light irradiation is performed by making use of the gate electrode 12 as a part of the mask wherein a part of the electroconductive paste layer 11 is exposed to the light from the side of the gate electrode. Such utilization of the gate electrode as the mask can allow a part of the photocurable electroconductive paste layer 11 to be irradiated with the light via the insulating layer 10, and thereby the irradiated part of the paste layer 11 is caused to be cured. The source and drain electrodes are given by such cured part of the paste layer 11. As the light beam 63 for the irradiation, a light beam having a wavelength capable of transmitting through the insulating layer 10 and also capable of curing the electroconductive paste layer 11 may be used.

During this step of the light irradiation, the curing of a part of the electroconductive paste layer 11 can be performed by making use of the gate electrode 12 as a part of the mask, and thereby enabling the end face 31s of the source electrode 30s to be in alignment with the one end face 13 of the gate electrode 12, and also enabling the end face 31d of the drain electrode 30d to be in alignment with the other end face 13 of the gate electrode 12. This means that a self-aligned gate structure can be provided by this step of the light irradiation. Even in this self-aligned gate structure, there is possibility that somewhat errors relating to the misalignment among the end faces (13, 31s and 31d) due to the light diffraction/scattering or the like may occur, as described above.

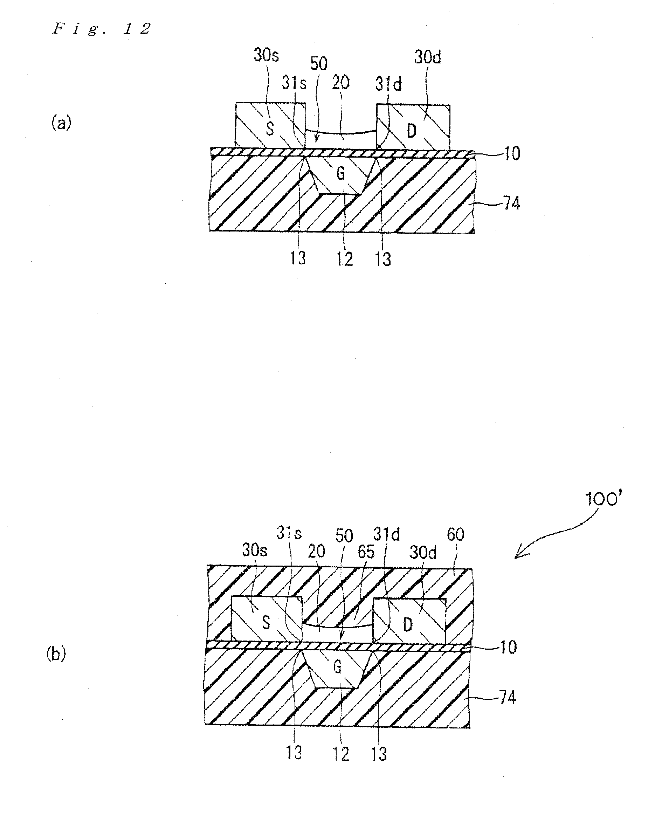

Subsequent to the formation of the source and drain electrodes, as shown in Fig. 11 (c), a resin film layer 74 is formed over the surface of the insulating layer 10 so as to cover the gate electrode 12, and thereafter the supporting substrate 73 is removed. Subsequently, after the removal of the uncured portion of the electroconductive paste layer 11, the semiconductor layer 20 is formed between the source electrode 30s and the drain electrode 30d by making use of the both electrodes (30s/30d) as the bank member as shown in Fig. 12(a). Thereafter, a resin film layer 60 is formed so as to cover the semiconductor layer 20 and the source/drain electrode (30s/30d) as shown in Fig. 12(b). A part of the resin film layer 60 becomes an interfitting portion 65 which is located within the clearance portion 50. As a result, there can be finally obtained the flexible semiconductor device 100' according to the present invention.

Even the above mask embodiment of the present invention can also provide the self-aligned gate structure. That is, the formation of the source electrode 30s and the drain electrode 30d can be performed by utilizing the gate electrode 12 as a part of the mask so that the electroconductive paste layer 11 is allowed to be partially cured. Therefore, the mutual positional relationship among the gate electrode 12, the source electrode 30s and the drain electrode 30d can be automatically provided without performing the mask alignment which tends to cause errors.

### 〈〈Image Display Device equipped with the Flexible Semiconductor Device〉〉

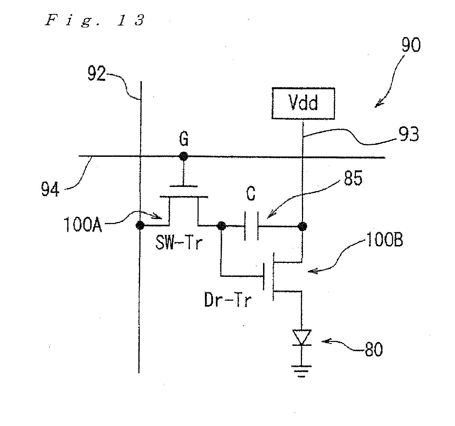

With reference to Fig. 13, an embodiment wherein the flexible semiconductor device 100 of the present invention is utilized in an image display device will be explained (it should be noted that the same is true for an embodiment wherein the flexible semiconductor device 100' of the present invention is utilized in an image display device). The circuit 90 shown in Fig. 13 is a driving circuit which is mounted on an image display device (e.g., organic electroluminescence display), and Fig. 13 shows a constitution of one pixel in the image display device. Each pixel in the image display device according to the present invention comprises a circuit with a combination of two transistors (100A, 100B) and one capacitor 85. This driving circuit includes a switching transistor (hereinafter, referred to as "Sw-Tr") 100A and a driving transistor (hereinafter, referred to as "Dr-Tr") 100B, both of which consist of the flexible semiconductor device 100 of the present invention. It is possible that the structure of the flexible semiconductor device 100 is provided with a capacitor 85, in which case the insulating layer 10 in the present invention can be used as a dielectric layer of the capacitor 85.

More specifically, a gate electrode of Sw-Tr 100A is connected to a selection line 94. As for the source electrode and the drain electrode of Sw-Tr 100A, one thereof is connected to a data line 92 and the other thereof is connected to a gate electrode of Dr-Tr 100B. As for the source electrode and the drain electrode of Dr-Tr 100B, one thereof is connected to a power line 93 and the other thereof is connected to a display area 80 (e.g., an organic electroluminescence element). The capacitor 85 is connected to the region between the source electrode and the gate electrode of Dr-Tr 100B.

As for the above pixel circuit, when the switch of Sw-Tr 100A is set "ON" during the activation of the selection line 94, a driving voltage is supplied from data line 92 and selected by Sw-Tr 100A, and thereby the electric charge is stored in the capacitor 85. Then, a voltage resulted from the above charge is applied to the gate electrode of Dr-Tr 100B, and thereby a drain electric current corresponding to the voltage is supplied to the display area 80, which causes the display area (organic electroluminescence element) 80 to emit light.

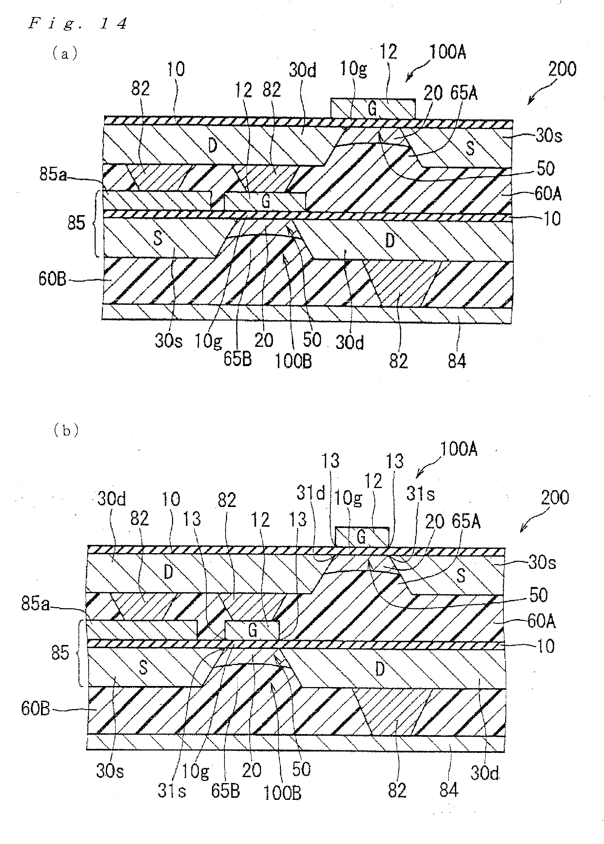

Figs. 14(a) and 14(b) show a laminated body 200 wherein a circuit 90 is constructed by the flexible semiconductor device 100 of the present invention (100A, 100B).

In the laminated body 200 shown in Figs. 14(a) and 14(b), the flexible semiconductor device 100A is located in the upper side portion thereof, whereas the flexible semiconductor device 100B is located in the lower side portion thereof. A drain electrode 30d of the flexible semiconductor device 100A is in a contact with a gate electrode 12 of the flexible semiconductor device 100B by means of a via 82. The drain electrode 30d of the flexible semiconductor device 100A is also in a contact with an upper electrode 85a of the capacitor 85 by means of another via 82. A dielectric layer of the capacitor 85 is provided by the insulating layer 10 by which the gate insulating film 10g of the flexible semiconductor device 100B is also provided. A lower electrode 85a of the capacitor 85 is an electrode which continuously extends from a source electrode 30s of the flexible semiconductor device 100B. A drain electrode 30d of the flexible semiconductor device 100B is in a contact with a wiring 84 via another via 82.

A protruding portion 65A of a resin film 60A is located within the clearance portion 50 of the flexible semiconductor device 100A. While on the other hand, a protruding portion 65B of a resin film 60B is located within the clearance portion 50 of the flexible semiconductor device 100B. Each of the protruding portions 65 (65A, 65B) forms the interfitting structure (i.e., interdigitating structure). Accordingly, the laminated body 200 as shown provides an advantageous effect in that a part around each channel area of the flexible semiconductor devices 100 (100A, 100B) can serve as the interdigitating structure, and thus there is no need to separately and additionally provide another interdigitate structure other than that in order to improve the adhesion. As seen from Fig. 14(b) wherein the mask embodiment according to the present invention is shown, each of the flexible semiconductor devices 100A, 100B has a self-aligned gate structure. That is, according to the mask embodiment of the present invention, end faces 13 of the gate electrode 12 are in alignment with an end face 31s of the source electrode 30s and an end face 31d of the drain electrode 30d in each of the flexible semiconductor devices 100A, 100B.

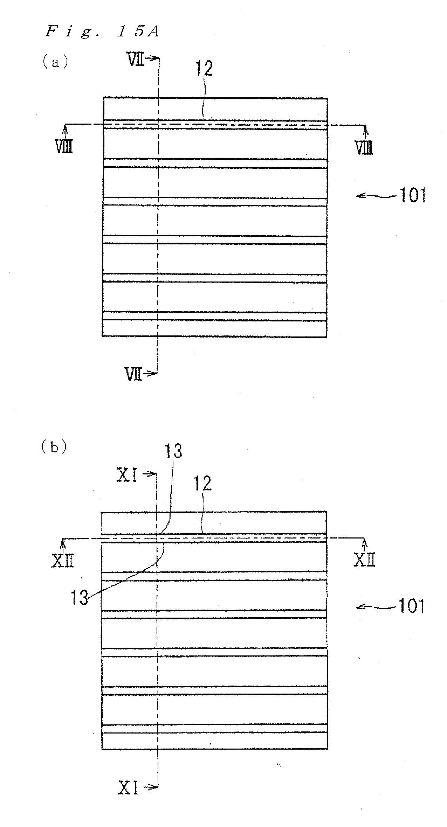

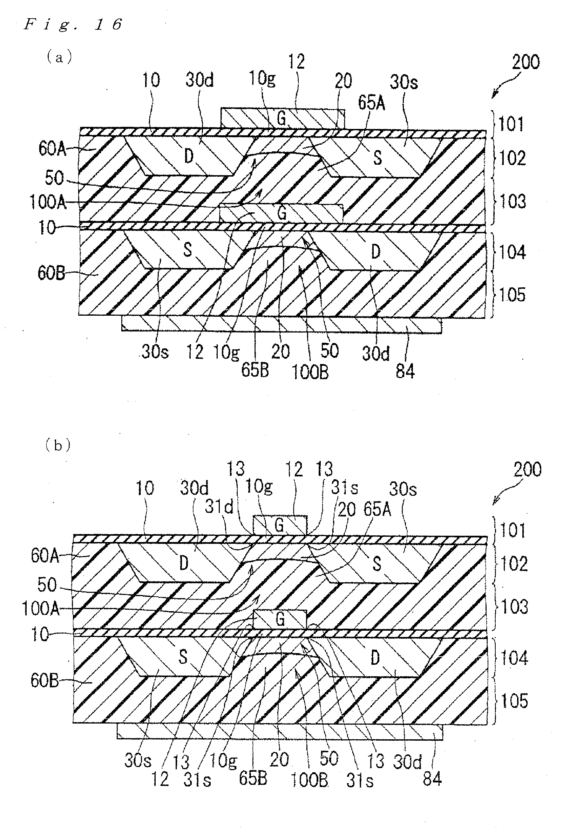

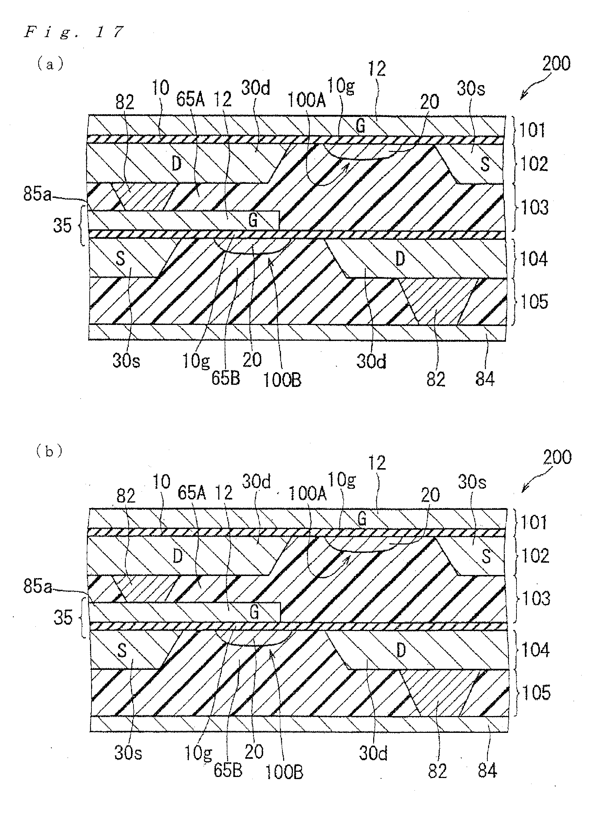

Another laminated body 200 wherein the circuit 90 is constructed by the flexible semiconductor devices 100 (100A, 100B) of the present invention will be now described. Figs. 15A(a) and 15A(b) through 15E(a) and 15E(b) are plan views schematically showing layers (101-105) of the another laminated body 200. Fig. 16(a) is a sectional view (enlarged view) taken along the line VII-VII of Figs. 15A(a) to 15E(a), whereas Fig. 16(b) is a sectional view (enlarged view) taken along the line XI-XI of Figs. 15A(b) to 15E(b). Fig. 17(a) is a sectional view (enlarged view) taken along the line VIII-VIII of Figs. 15A(a) to 15E(a), whereas Fig. 17(b) is a sectional view (enlarged view) taken along the line XII-XII of Figs. 15A(b) to 15E(b).

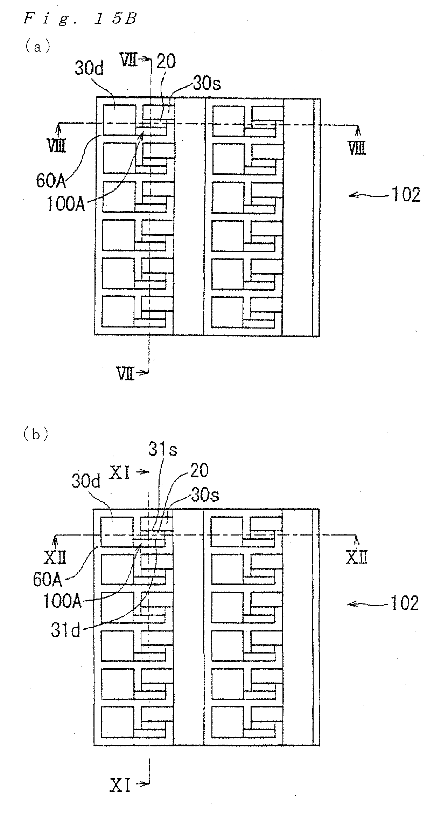

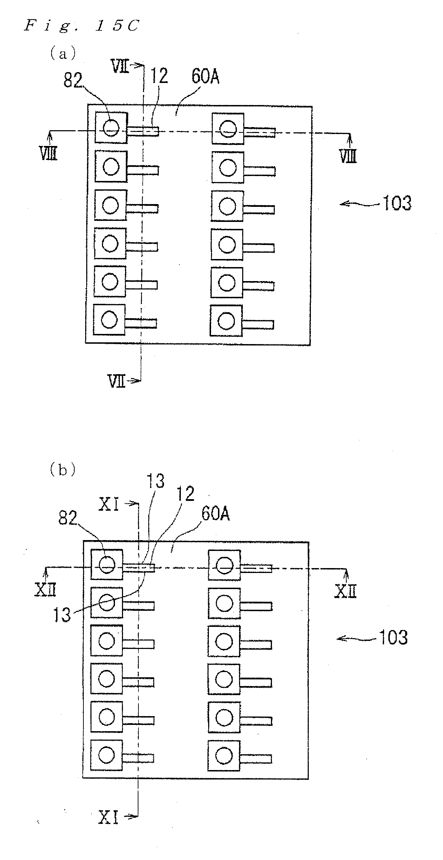

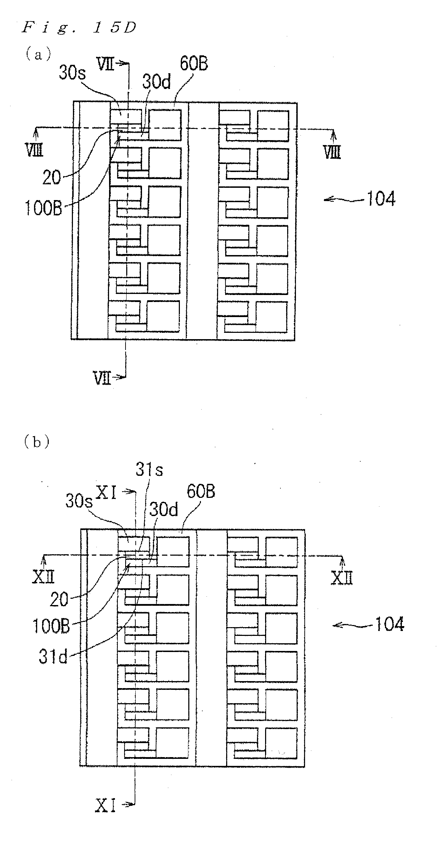

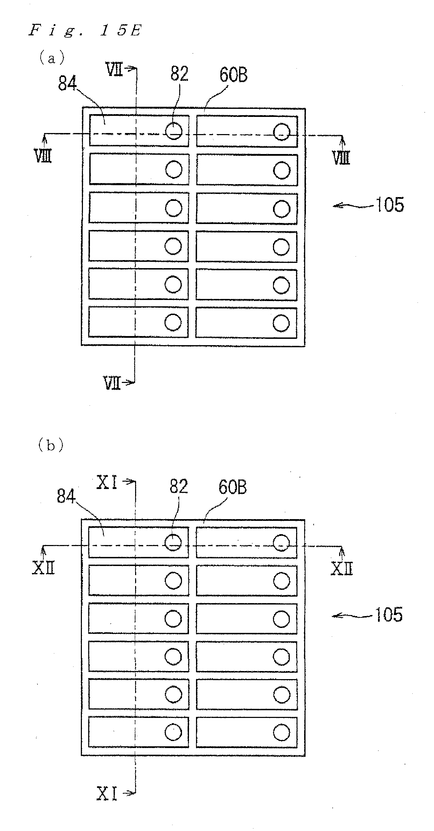

In the layer 101 shown in Figs. 15A(a) and 15A(b), a gate electrode 12 is provided. In the layer 102 shown in Figs. 15B(a) and 15B(b), a source electrode 30s, a drain electrode 30d and a semiconductor layer 20 therebetween (30s, 30d) are located. In the layer 103 shown in Figs. 15C(a) and 15C(b), a gate electrode 12 and a via 82 are located. In the layer 104 shown in Figs. 15D(a) and 15D(b), a source electrode 30s, a drain electrode 30d and a semiconductor layer 20 therebetween (30s, 30d) are located. In the layer 105 shown in Figs. 15E(a) and 15E(b), a wiring 84 and a via 82 are located.

As shown in Figs. 16(a) and 16(b), a protruding 65A of a resin film 60A interdigitates with the clearance portion 50 of the flexible semiconductor device 100A, whereas a protruding 65B of a resin film 60B interdigitates with the clearance portion 50 of the flexible semiconductor device 100B. As shown in Figs. 14(a) and 14(b), a dielectric layer 10 of a capacitor 85 is one which is the same as a gate insulating film 10g. As seen from Figs. 14(b) and 16(b) wherein the mask embodiment according to the present invention is shown, each of the flexible semiconductor devices 100A, 100B has a self-aligned gate structure.

Next, an embodiment where an image display unit is produced on the transistor or circuit comprising the transistors (particularly, an embodiment about the image display unit composed of a plurality of pixels over the flexible semiconductor device) will be explained.

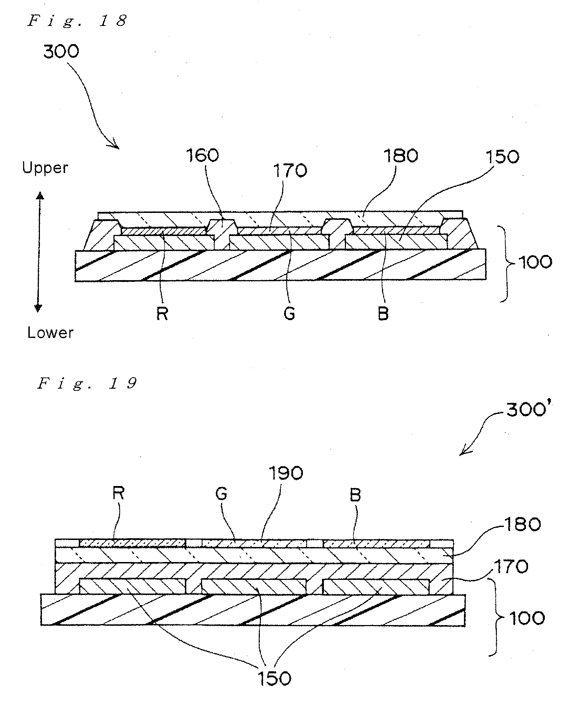

Fig. 18 is a sectional view of an OLED (organic electroluminescence) image display device 300 wherein three colors consisting of R (red), G (green) and B (blue) are used in three pixels on the flexible semiconductor device of the present invention. The semiconductor device is illustrated only by a resin film and pixel electrodes (cathodes). In such image display device 300, each light emitting layer 170 is arranged on each pixel electrode 150 consisting of R, G and B pixels where the luminescent materials of the light emitting layers respectively correspond to the respective ones of R, G and B. Pixel regulating parts 160 are provided between the adjacent pixels to prevent the adjacent luminescent materials from being intermingled with each other as well as to facilitate the positioning upon the arrangement of the EL materials. A transparent electrode layer (anode layer) 180 is provided over the light emitting layer 170 such that it covers the whole of each pixel.

Examples of the materials to be used for the pixel electrodes 150 include a metal (e.g., Cu). The pixel electrode may have a stacked layer structure composed of a charge injection layer and a surface layer (e.g., Al surface layer with its thickness of 0.1 µm) wherein the charge injection layer functions to improve a charge injection efficiency with respect to the light emitting layer 170, and the surface layer functions to improve a light extraction efficiency in upward direction by reflecting a light emitted from the light emitting layer. In this regard, the pixel electrode may be a reflection electrode with Al/Cu stacked layer structure, for example.

Examples of the material to be used for the light emitting layer 170 include, but not limited to, a polyfluorene-based electroluminescent material and a dendrimer-based light emitting material having a dendritically branched structure wherein at least one heavy metal (e.g., Ir or Pt) is positioned at the center of a dendron backbone of a so-called dendrimer. The light emitting layer 170 may have a single layer structure. Alternatively, the light emitting layer 170 may have a stacked layer structure with an electron injection layer/a light emitting layer/a hole injection layer by using MoO₃ for the hole injection layer (to facilitate the injection of charge) and LiF for the electron injection layer. As the transparent electrode 180 of the anode, ITO may be used.

As for the pixel regulating part 160, it may be made of an insulating material. For example, a photosensitive resin mainly comprising polyimide, or SiN can be used as the insulating material of the pixel regulating part.

The image display device may be configured to have a structure with a color filter as shown in Fig. 19. The image display device 300' as shown in Fig. 19 comprises the flexible semiconductor device 100, a plurality of pixel electrodes 150 provided on the flexible semiconductor device 100, a light emitting layer 170 provided such that it wholly covers the pixel electrodes 150, a transparent electrode layer 180 provided on the light emitting layer 170, and a color filter 190 provided on the transparent electrode layer 180. In the image display device 300', the color filter 190 has a function to convert lights emitted from the light emitting layer 170 to three kinds of lights of red, green and blue, and thereby three kinds of pixels consisting of R(red), G(green) and B(blue) are used. As for the image display device 300 shown in Fig. 18, each of the light emitting layers separated by the pixel regulating parts 160 emits each of red, green and blue lights separately. While on the other hand, as for the image display device 300' shown in Fig. 19, the light emitted from the light emitting layer has no difference in color (i.e., the light emitting layer emits white light), but the passing of the light through the color filter 190 causes the generation of each of red, green and blue lights.

### (Manufacturing Method of Image Display Device)

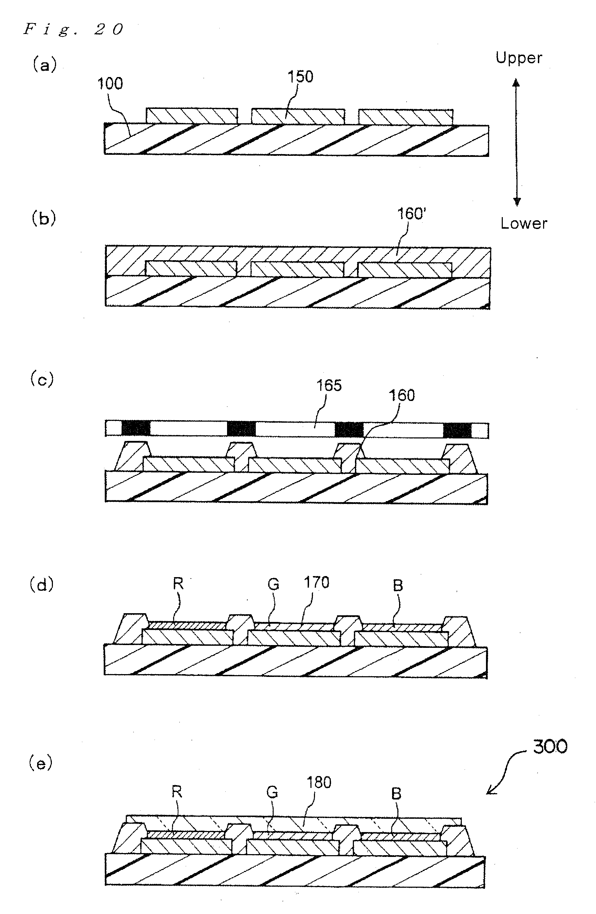

Next, a manufacturing method of the image display device will be explained. Specifically, a manufacturing method of OLED according to the present embodiment will be explained with reference to Fig. 20.

First, the flexible semiconductor device 100 equipped with pixel electrodes 150 is prepared as shown in Fig. 20(a). Specifically, the pixel electrodes 150 can be provided by subjecting the metal foil to a patterning treatment (that is, the pixel electrodes 150 can be formed by etching away the part of the metal foil provided on the flexible film layer by the photolithography process or the like) upon the manufacturing process of the flexible semiconductor device 100. Alternatively, the pixel electrodes 150 can be provided by applying the raw materials for the pixel electrodes by a printing process or the like at predetermined portions upon the manufacturing process of the flexible semiconductor device 100.

Subsequent to the provision of the pixel electrodes, an image display unit composed of a plurality of pixels is formed over the flexible semiconductor device. For example, as shown in Figs. 20(b) to 20(d), a plurality of pixel regulating parts 160 are formed on the flexible semiconductor device 100, and then each light emitting layer 170 is formed on a region of each pixel electrode 150, the region being partitioned by the pixel regulating parts 160. The pixel regulating parts 160 can be formed, for example, by forming a precursor layer 160' for the pixel regulating parts wherein the pixel electrodes as a whole are covered with a photosensitive resin material mainly consisting of polyimide, followed by subjecting the precursor layer 160' to a photolithography process. Light emitting layers 170 of the predetermined colors are respectively formed on the corresponding ones of the pixel electrodes. The light emitting layers 170 can be formed, for example, by applying a solution of a polyfluorene-based electroluminescent material (1%) dissolved into xylene onto the pixel electrodes by performing an ink jet process. The light emitting layer 170 may have a thickness of about 80 nm, for example.

Subsequent to the formation of the light emitting layer 170, a transparent electroconductive layer 180 (e.g., ITO film) is formed so as to cover the light emitting layers 170. The transparent electroconductive layer consisting of the ITO film can be formed by performing a sputtering process.

According to the above processes, there can be finally obtained the image display device 300 having the structures as shown in Fig. 20(e) and Fig. 18.

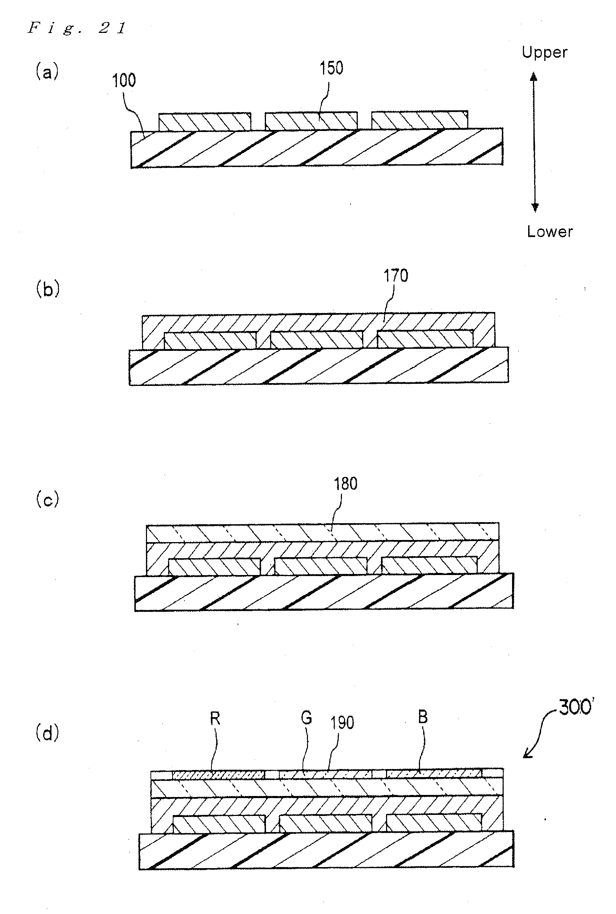

As an alternative embodiment, the manufacturing process of the image display device 300' equipped with a color filter will now be explained. This manufacturing process is substantially the same as that of the above mentioned manufacturing process, while there are some partial differences. Specifically, after the provision of the pixel electrodes as mentioned above (see, Fig. 21(a)), a light emitting layer 170 capable of emitting white color is wholly laminated in the form of a film (see Fig. 21 (b)). Subsequently, a transparent electrode layer 180 is formed in the same manner as mentioned above (see Fig. 21 (c)). Thereafter, the color filter 190 capable of emitting R(red), G(green) and B(blue) is formed such that each color of the filter is arranged at each of the corresponding pixel positions (see Fig. 21 (d)). As a result of the above processes, there can be finally obtained the image display device 300'.

### 〈〈Roll-to-Roll Process〉〉

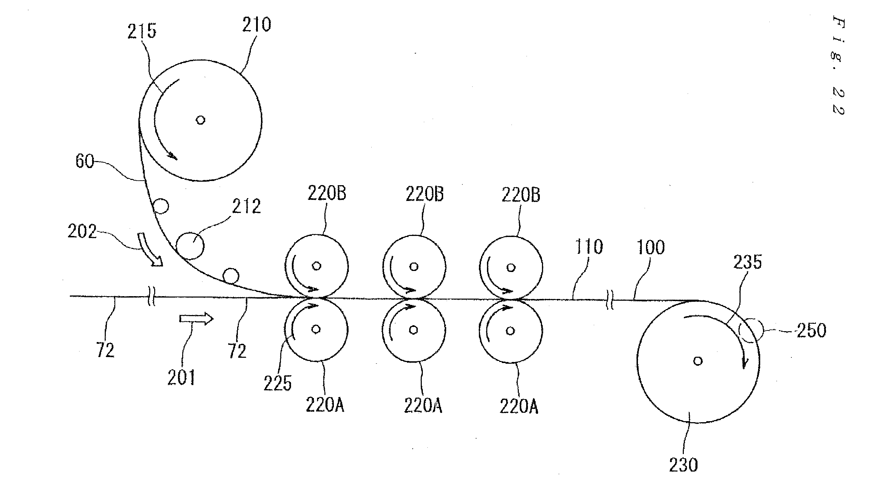

The flexible semiconductor device 100 of the present invention is "flexible", and thus it can be suitably manufactured through a roll-to-roll process. Fig. 22 shows an embodiment where the flexible semiconductor device 100 is being manufactured by the roll-to-roll process.

According to the roll-to-roll process, the supporting substrate 72 on which the semiconductor layers 20-containing transistors (TFT) are provided (that is, the structured bodies as shown in Fig. 3(a) or 7(a) are provided) is conveyed such that it passes a pair of rollers 220A, 220B, together with a resin film 60 as shown in Fig. 22. This passing produces a laminated body 110 wherein the "supporting substrate 72 provided with the transistors" and the "resin film 60" are integrated with each other (that is, the structure as shown in Fig. 3(b) or 7(b) is provided).

More detailed explanation about this is as follows: The supporting substrate 72 provided with the transistors (TFT) (the structures as shown in Fig. 3 (a) or 7(a)) is conveyed in the direction of the arrow 201. While on the other hand, the resin film 60, which is unrolled from the roller 210 (see the arrow 215), is conveyed in the direction of the arrow 202 along an auxiliary roller 212. Subsequently, the metal foil 70 and the resin film 60 are laminated so that they are integrated with each other by passing the space between a pair of heating and pressurizing rollers (220A, 220B) which are rotating in the direction of the arrow 225.

Upon such laminating and integrating process, a part 65 of the resin film layer 60 is forced to be inserted into the clearance portion 50 of the metal foil 70, and thereby the interdigitate structure is formed. After the completion of the laminating and integrating process, the metal foil laminated with the resin film 110 (i.e., the film laminate) is wound up by the roller 230 (see arrow 235). In a case where the supporting substrate 72 is made of metal and the gate electrode 12 is formed by a patterning process of the supporting substrate 72, the film laminate may be sent to an etching process wherein the patterning treatment (not shown) is performed to obtain the flexible semiconductor device 100, followed by being wound up by the roller 230.

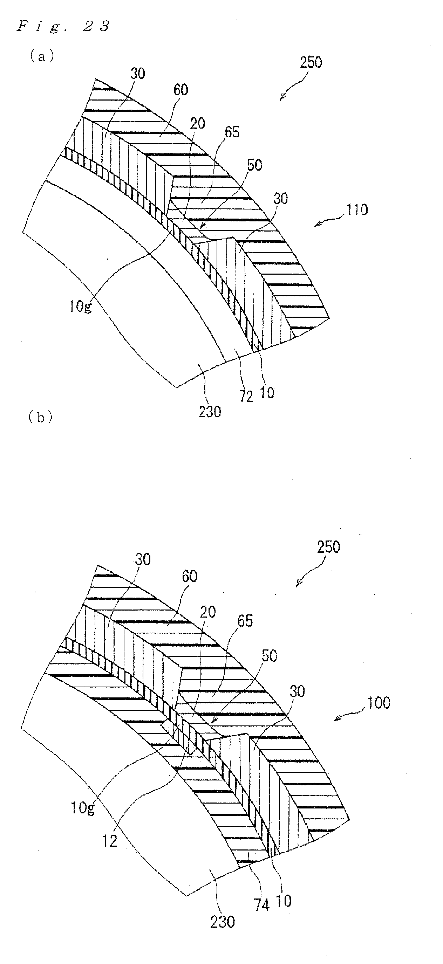

Figs. 23(a) and 23(b) respectively show a sectional view of a part 250 of the laminated body 110 which has been wound up by the roller 230. As shown in Figs. 23(a) and 23(b), the source and drain electrodes 30 are positioned inside and the resin film 60 is positioned outside around the roller 230, which leads to a compression of the source and drain electrodes 30 as well as a stretching of the supporting substrate 60. As a result, the degree of the warping of the source and drain electrodes 30 becomes different from that of the resin film 60, which can generate any sheer stress on the interface therebetween, and thereby inducing the peeling phenomenon in the laminated structure. In the case of the conventional laminated structure, the generation of the peeling phenomenon is suppressed only by the adhering strength between the source and drain electrodes 30 (the patterned metal foil 70) and the resin film 60. In this regard, according to the present invention, the laminated structure is strongly held by the interdigitate structure (50, 65) in addition to the adhesion strength, so that the tight adhesiveness is improved, which can lead to a prevention or reduction of the occurrence of the peeling phenomenon.

With respect to the embodiment shown in Fig. 22, it is possible to adopt a step wherein the laminated body 110 is wound up by the roller 230, and then the supporting substrate 72 is removed therefrom, followed by the formation of the gate electrode 12 in a separate process. Alternatively, it is also possible to unroll the metal foil 70 from a roller provided at an initial stage (not shown) and is sequentially subjected to all the processes (or a part thereof) shown in Fig. 2(a) to Fig. 3(c) by means of rollers, a chamber, an etching bath and the like.

### 〈〈Modification of Semiconductor Layer〉〉

As mentioned in the above, the modification of the semiconductor layer can be easily and effectively performed according to the present invention. Particularly, it is possible to perform the modification of the semiconductor layer 20 made of an oxide semiconductor. For example, in a case of the crystalline oxide semiconductor such as ZnO, there are relatively large amount of amorphous state in the crystalline layer immediately after being formed as a film by a sputtering and the like, and thereby frequently failing to show the properties of the semiconductor (i.e., performance of the semiconductor device). However, according to the present invention, the device as shown in Fig. 3(a) or 7(a), that is, the device where the clearance portion 50 is filled with the semiconductor material (i.e., the oxide semiconductor in this case) has a structure composed of the source and drain electrodes 30(30s, 30d), the insulating layer 10 and the semiconductor material 20 (i.e., the structure with the supporting substrate 72 other than the above elements) while being flexibility, and thereby the annealing process or laser irradiation process can be performed without significant restrictions. The performing of the annealing process or laser irradiation process can improve the crystallinity of the oxide semiconductors (e.g., ZnO), which leads to an improved performance of the semiconductor.

As an example regarding the above, when ZnO is formed by a RF magnetron sputtering process in the order of the formations of ZnO film (50 nm) and SiO₂ film (50 nm), the formed layer does not show the properties of the semiconductor at the point time before the irradiating with excimer laser. While on the other hand, after the irradiation with XeCl excimer laser is performed, the layer become capable of functioning as the semiconductor and thus it can have a mobility of about 20cm²/Vs.

Also as for the amorphous oxide semiconductor such as InGaZnO, the effects of improving the semiconductor properties can be provided. In the case of the amorphous oxide semiconductor, an oxygen deficiency can be restored and thus the mobility can be improved due to the laser irradiation under the oxygen atmosphere (for example, air atmosphere) and also under such a condition that the clearance portion 50 is filled with the semiconductor material (i.e., amorphous oxide semiconductor material). When the TFT is produced using InGaZnO as the semiconductor material, the very low mobility before the laser irradiation can be increased to the degree of about 10cm²/Vs after the laser irradiation.

Moreover, an electroconductivity control of the oxide semiconductor can be performed. More oxygen deficiency means that there may exist many conduction electrons (that is, the carrier concentration is high), and thus means that the electroconductivity is high. In order to restore the oxygen deficiency (i.e. in order to introduce oxygen), it is suitable to expose the oxide semiconductor to an oxygen atmosphere at a high temperature. Instead of the high temperature, it is also suitable to apply the energy to the oxide semiconductor in the energy form of laser, plasma, ozone or the like.

As an example regarding the above, the electroconductivity control of the oxide semiconductor can be performed by selectively annealing the channel area 22 with laser under the oxygen atmosphere after the filling of the clearance portion 50 with the semiconductor material (i.e., oxide semiconductor material in this case, and the material has the more oxygen deficiency at the point time when before the annealing treatment). With the H plasma (hydrogen plasma) treatment, the atmosphere becomes reductive, thereby facilitating the generation of the oxygen deficiency in the oxide semiconductor.

### 〈〈Summarized Invention〉〉

In general, the present invention as described above includes the following aspects:
The first aspect: A flexible semiconductor device comprising :
   a gate electrode;
   an insulating layer disposed on the gate electrode, the insulating layer having a portion serving as a gate insulating film; and
   a source electrode and a drain electrode provided on the insulating layer, the source and drain electrodes being formed of a metal foil,
   wherein there is provided a clearance portion between the source electrode and the drain electrode, and thereby the source and drain electrodes between which the clearance portion intervenes are a bank member;
   a semiconductor layer is provided in the clearance portion; and
   a resin film layer is provided over the insulating layer such that the semiconductor layer, the source electrode and the drain electrode are covered with the resin film layer, and the resin film layer is provided with a protruding portion which is interfitted with the clearance portion.
   The second aspect: The flexible semiconductor device according to the first aspect, wherein opposed end faces of the source and drain electrodes, between which the clearance portion intervenes, are inclined.
   The third aspect: The flexible semiconductor device according to the first or second aspect, wherein the protruding portion of the resin film layer and the clearance portion located between the source and drain electrodes are in complementary form with respect to each other.
   The fourth aspect: The flexible semiconductor device according to any one of the first to third aspects, wherein the semiconductor layer comprises silicon.
   The fifth aspect: The flexible semiconductor device according to any one of the first to third aspects, wherein the semiconductor layer comprises an oxide semiconductor.
   The sixth aspect: The flexible semiconductor device according to the fifth aspect, wherein the oxide semiconductor is ZnO or InGaZnO semiconductor.
   The seventh aspect: The flexible semiconductor device according to any one of the first to sixth aspects, wherein the gate insulating film is made of an inorganic material.
   The eighth aspect: The flexible semiconductor device according to any one of the first to sixth aspects, wherein the metal foil comprises a valve metal; and the gate insulating film is an anodically-oxidized film of the valve metal.
   The ninth aspect: An image display device using the flexible semiconductor device according to any one of the first to eighth aspects, the image display device comprising:
   the flexible semiconductor device; and
   an image display unit composed of a plurality of pixels, the unit being provided over the flexible semiconductor device,
   wherein the clearance portion is provided between the source and drain electrodes of the flexible semiconductor device, and thereby the source and drain electrodes between which the clearance portion intervenes are the bank member;
   the semiconductor layer of the flexible semiconductor device is provided in the clearance portion; and
   the resin film layer of the flexible semiconductor device is provided with the protruding portion which is interfitted with the clearance portion.
   The tenth aspect: The image display device according to the ninth aspect, wherein the image display unit comprises:
   a pixel electrode provided on the flexible semiconductor device;
   a light emitting layer provided over the pixel electrode; and
   a transparent electrode layer provided on the light emitting layer.
   The eleventh aspect: The image display device according to the tenth aspect, wherein the light emitting layer is provided at a region partitioned by a pixel regulating part.
   The twelfth aspect: The image display device according to the tenth aspect, wherein a color filter is provided on the transparent electrode layer.
   The thirteenth aspect: A method for manufacturing a flexible semiconductor device, the method comprising the steps of:
   (A) providing a metal foil;
   (B) forming an insulating layer on the metal foil, the insulating layer having a portion serving as a gate insulating film;
   (C) forming a supporting substrate on the insulating layer;
   (D) etching away a part of the metal foil to form a source electrode and a drain electrode therefrom;
   (E) forming a semiconductor layer in a clearance portion located between the source electrode and the drain electrode by making use of the source and drain electrodes as a bank member; and
   (F) forming a resin film layer over the insulating layer such that the resin film layer covers the semiconductor layer, the source electrode and the drain electrode,
   wherein, in the step (F), a part of the resin film layer interfits with the clearance portion located between the source and drain electrodes.
The fourteenth aspect: The method according to the thirteenth aspect, wherein the metal foil is subjected to a photolithography process and a wet etching process in the step (D), and thereby forming inclined opposed end faces of the source and drain electrodes, between which the clearance portion intervenes.
The fifteenth aspect: The method according to the thirteenth or fourteenth aspect, wherein the step (F) is performed by a roll-to-roll process.
The sixteenth aspect: The method according to any one of the thirteenth to fifteenth aspects, wherein, after a removal of the supporting substrate, a gate electrode is formed on the surface of a portion of the insulating layer, the portion corresponding to the gate insulating film.
The seventeenth aspect: The method according to any one of the thirteenth to sixteenth aspects, wherein a ceramic substrate or a metal substrate is used as the supporting substrate.
The eighteenth aspect: The method according to any one of the thirteenth to seventeenth aspects, wherein, in the step (B), the gate insulating film is formed by a sol-gel process.
The nineteenth aspect: The method according to the seventeenth aspect, wherein, after the step (B), the gate insulating film is subjected to a heat treatment.
The twentieth aspect: The method according to the seventeenth or nineteenth aspect, wherein, after the step (E), the semiconductor layer is subjected to a heat treatment.
The twenty-first aspect: The method according to any one of the thirteenth to fifteenth aspects, wherein, a metal substrate is used as the supporting substrate; and
after the step (F), the metal substrate is subjected to a pattering process to form a gate electrode therefrom.
The twenty-second aspect: A flexible semiconductor device comprising :
an insulating layer having a portion serving as a gate insulating film; and
a source electrode and a drain electrode provided on the insulating layer, the source and drain electrodes being formed of a metal foil
wherein a semiconductor layer is provided in a clearance portion between the source electrode and the drain electrode;
a gate electrode is provided on a principal surface of the insulating layer, the principal surface being on the side opposite to another principal surface thereof on which the source and drain electrodes are provided; and
one of end faces of the source electrode and one of end faces of the gate electrode are in alignment with each other, and one of end faces of the drain electrode and the other of end faces of the gate electrode are in alignment with each other.
The twenty-third aspect: The flexible semiconductor device according to the twenty-second aspect, wherein the end faces of the gate electrode are coincident with the ones of the end faces of the source and drain electrodes such that they are self-aligned with each other.
The twenty-fourth aspect: The flexible semiconductor device according to the twenty-second aspect, wherein a contact point "A" between the insulating layer and the one of the end faces of the source electrode is opposed to a contact point "B" between the insulating layer and the one of the end faces of the gate electrode; and
a contact point "C" between the insulating layer and the one of the end faces of the drain electrode is opposed to a contact point "D" between the insulating layer and the other of the end faces of the gate electrode.
The twenty-fifth aspect: The flexible semiconductor device according to any one of the twenty-second to twenty-fourth aspects, wherein opposed end faces of the source and drain electrodes, between which the clearance portion intervenes, are inclined.
The twenty-sixth aspect: The flexible semiconductor device according to any one of the twenty-second to twenty-fifth aspects, wherein a resin film layer is provided over the insulating layer such that the semiconductor layer, the source electrode and the drain electrode are covered with the resin film layer; and
the protruding portion of the resin film layer and the clearance portion located between the source and drain electrodes are in complementary form with respect to each other.
The twenty-seventh aspect: The flexible semiconductor device according to any one of the twenty-second to twenty-sixth aspects, wherein the semiconductor layer comprises silicon.
The twenty-eighth aspect: The flexible semiconductor device according to any one of the twenty-second to twenty-sixth aspects, wherein the semiconductor layer comprises an oxide semiconductor.
The twenty-ninth aspect: The flexible semiconductor device according to the twenty-eighth aspect, wherein the oxide semiconductor is ZnO or InGaZnO semiconductor.
The thirtieth aspect: The flexible semiconductor device according to any one of the twenty-second to twenty-ninth aspects, wherein the gate insulating film is made of an inorganic material.
The thirty-first aspect: The flexible semiconductor device according to any one of the twenty-second to twenty-ninth aspects, wherein the metal foil comprises a valve metal; and
the gate insulating film is an anodically-oxidized film of the valve metal.
The thirty-second aspect: An image display device using the flexible semiconductor device according to any one of the twenty-second to thirty-first aspects, the image display device comprising:
the flexible semiconductor device; and
an image display unit composed of a plurality of pixels, the unit being provided over the flexible semiconductor device,
wherein, in the flexible semiconductor device, one of end faces of the source electrode and one of end faces of the gate electrode are in alignment with each other, and one of end faces of the drain electrode and the other of end faces of the gate electrode are in alignment with each other.
The thirty-third aspect: The image display device according to the thirty-second aspect, wherein the image display unit comprises:
a pixel electrode provided on the flexible semiconductor device;
a light emitting layer provided over the pixel electrode; and
a transparent electrode layer provided on the light emitting layer.
The thirty-fourth aspect: The image display device according to the thirty-third aspect, wherein the light emitting layer is provided at a region partitioned by a pixel regulating part.
The thirty-fifth aspect: The image display device according to the thirty-third aspect, wherein a color filter is provided on the transparent electrode layer.
The thirty-sixth aspect: A method for manufacturing a flexible semiconductor device, the method comprising the steps of:
(A)' providing a metal foil;
(B)' forming an insulating layer on the metal foil, the insulating layer having a portion serving as a gate insulating film;
(C)' etching away a part of the metal foil to form a source electrode and a drain electrode therefrom;
(D)' supply a photocurable electroconductive paste on a principal surface of the insulating layer, the principal surface being on the side opposite to another principal surface thereof on which a semiconductor layer is formed, and thereby forming a photocurable electroconductive paste layer from the paste; and
(E)' forming a gate electrode by making use of the source and drain electrodes as a mask wherein a light irradiation is performed from the side of the source and drain electrodes, and thereby allowing a part of the photocurable electroconductive paste layer to be cured.
The thirty-seventh aspect: The process according to the thirty-sixth aspect, wherein, after the step (C)', a semiconductor layer is formed on the another principal surface of the insulating layer such that the semiconductor layer is accommodated in the clearance portion located between the source and drain electrodes; and
in the step (E)', the irradiation light passes through the semiconductor layer, and thereafter the curing of the part of the photocurable electroconductive paste layer is performed.
The thirty-eighth aspect: The process according to the thirty-seventh aspect, wherein, upon the formation of the semiconductor layer, a raw materials for the semiconductor layer is supplied to the clearance portion located between the source and drain electrodes by making use of the source and drain electrodes as a bank member.
The thirty-ninth aspect: The method according to any one of the thirty-sixth to thirty-eighth aspects, wherein the metal foil is subjected to a photolithography process and a wet etching process in the step (C)', and thereby forming inclined opposed end faces of the source and drain electrodes.
The fortieth aspect: The method according to the thirty-eighth or thirty-ninth aspect when appendant to the thirty-seventh aspect, further comprising the step for forming a resin film layer over the insulating layer such that the resin film layer covers the semiconductor layer, the source electrode and the drain electrode.
The forty-first aspect: The method according to the fortieth aspect, wherein a part of the resin film layer is forced to interfit with the clearance portion located between the source and drain electrodes upon the formation of the resin film layer.
The forty-second aspect: The method according to the fortieth or forty-first aspect, wherein the formation of the resin film layer is performed by a roll-to-roll process.
The forty-third aspect: The method according to any one of the thirty-sixth to forty-second aspects, wherein, in the step (B)', the gate insulating film is formed by a sol-gel process.
The forty-fourth aspect: The method according to any one of the thirty-sixth to forty-third aspects, wherein, after the step (B)', the gate insulating film is subjected to a heat treatment.
The forty-fifth aspect: The method according to any one of the thirty-eighth to forty-fourth aspects when appendant to the thirty-seventh aspect, further comprising the step for forming a supporting substrate on the insulating layer; and
the semiconductor layer is subjected to a heat treatment.
The forty-sixth aspect: A method for manufacturing a flexible semiconductor device, the method comprising the steps of:
(A)" providing a metal foil;
(B)" forming an insulating layer on the metal foil, the insulating layer having a portion serving as a gate insulating film;
(C)" supply a photocurable electroconductive paste on a principal surface of the insulating layer, the principal surface being on the side opposite to another principal surface thereof on which the gate electrode is to be formed, and thereby forming a photocurable electroconductive paste layer from the paste;
(D)" etching away a part of the metal foil to form a gate electrode therefrom; and
(E)" forming a source electrode and a drain electrode by making use of the gate electrode as a mask wherein a light irradiation is performed from the side of the gate electrode, and thereby allowing a part of the photocurable electroconductive paste layer to be cured.
The forty-seventh aspect: The process according to the forty-sixth aspect, wherein, after the step (E)", a semiconductor layer is formed on the principal surface of the insulating layer such that the semiconductor layer is accommodated in the clearance portion located between the source and drain electrodes; and
upon the formation of the semiconductor layer, a raw materials for the semiconductor layer is supplied to the clearance portion located between the source and drain electrodes by making use of the source and drain electrodes as a bank member.
The forty-eighth aspect: The process according to the forty-seventh aspect, further comprising the step for forming a resin film layer over the insulating layer such that the resin film layer covers the semiconductor layer, the source electrode and the drain electrode.
The forty-ninth aspect: The method according to the forty-eighth aspect, wherein a part of the resin film layer is forced to interfit with the clearance portion located between the source and drain electrodes upon the formation of the resin film layer.
The fiftieth aspect: The method according to the forty-eighth or forty-ninth aspect, wherein the formation of the resin film layer is performed by a roll-to-roll process.
The fifty-first aspect: A method for manufacturing an image display device using the flexible semiconductor device according to any one of the first to eighth aspects or twenty-second to thirty-first aspects,
(I) providing the flexible semiconductor device equipped with a pixel electrode; and
(II) forming an image display unit composed of a plurality of pixels over the flexible semiconductor device.
The fifty-second aspect: The method according to the fifty-first aspect, wherein, in the step (II), a plurality of pixel regulating parts are formed, and then the pixels are formed on regions of the pixel electrode, the regions being partitioned by the pixel regulating parts.
The fifty-third aspect: The method according to the fifty-first aspect, wherein, in the step (II), a light emitting layer is formed over the pixel electrode such that the light emitting layer covers the pixel electrode, and then a color filter is formed on the light emitting layer.

### 〈〈Modified embodiment of Present Invention〉〉

Although a few embodiments of the present invention have been hereinbefore described, the present invention is not limited to these embodiments. It will be readily appreciated by those skilled in the art that various modifications are possible without departing from the scope of the present invention.

For example, although the above mask embodiment of the present invention has been described based on the use of the Ag paste as the photocurable electroconductive paste, the present invention is not necessarily limited to that. For example, it is possible to use Cu particle instead of Ag particle, an unsaturated polyester resin as the photocurable electroconductive paste, or butyl carbitol acetate (BCA) as the photocurable electroconductive paste.

Moreover, although the above mask embodiment of the present invention has been described based on the light irradiation with a light beam having the wavelength of about 436 nm (so-called "g-ray light") wherein the resin film layer is made of an acrylate resin (PMMA) or a polycarbonate (PC), the gate insulating film is made of a silicon oxide, and the semiconductor layer is made of InGaZnO, the present invention is not necessarily limited to that. For example, the wavelength of the irradiation light may be suitably selected so that it is capable of allowing the curing of the photocurable electroconductive paste, and also capable of transmitting through the gate insulating film, the semiconductor layer and the resin film layer. As used herein, the term *"transmit"* does not mean that the light beam passes through at a passing rate of 100%, but means that the light beam may transmit so that the transmitted amount of the light is enough to allow the photocurable electroconductive paste to be cured. As a modified embodiment, a light beam having a wavelength of about 365nm (so-called "i-ray light") may be used.

As an additional remark, the functions of each component of the flexible semiconductor device of the present invention will be briefly explained. Each component of the flexible semiconductor device of the present invention is configured to be suitably available as the TFT (thin-film transistor). Although it is conceivable that a person skilled in the art can understand the operating principle of the TFT and the functions of each component thereof, they are as follows, especially regarding the present invention: Usually, a source electrode is in a state of zero potential and a necessary voltage is applied to a drain electrode. A semiconductor layer is provided in an area between the source electrode and the drain electrodes, which area is called as "channel area". The channel area is provided on a gate structure to contact with a gate insulating film. The gate structure is composed of the gate insulating film and a gate electrode. The applying of a voltage to the gate electrode can cause the electrical resistance of the channel area to change, and thereby changing the value of a current flowing between the source electrode and the drain electrode. This is a basic operating principal of the TFT and the functions of each component thereof. While the resin film does not directly relate to the operating of the above TFT, it performs the function to protect the components of the TFT (e.g., the source electrode) by sealing them, the function as the supporting substrate which mechanically holds the components of the TFT (e.g., the source electrode), and the function to provide the whole of semiconductor device with flexibility by the flexible property that the resin film itself has, and thereby ensuring the flexibility of the flexible semiconductor device as a whole.

### INDUSTRIAL APPLICABILITY

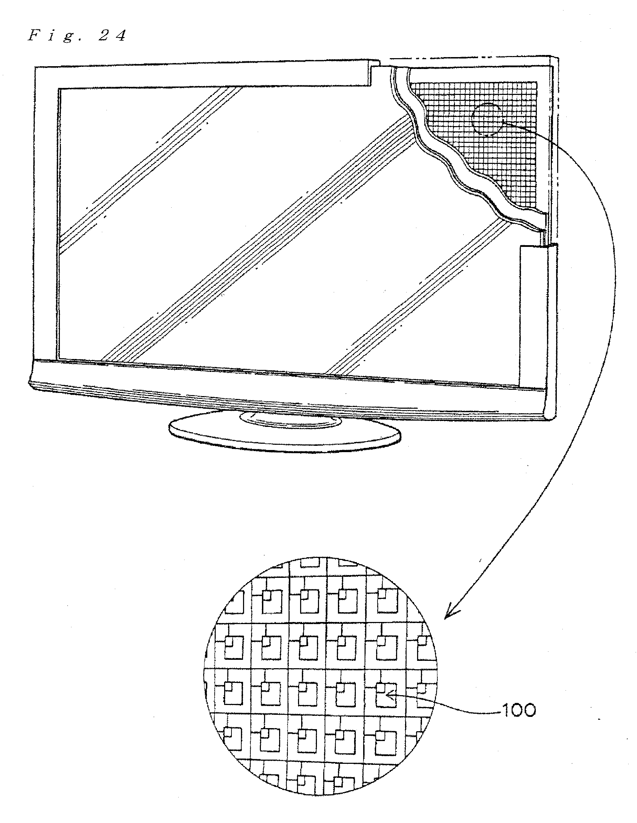

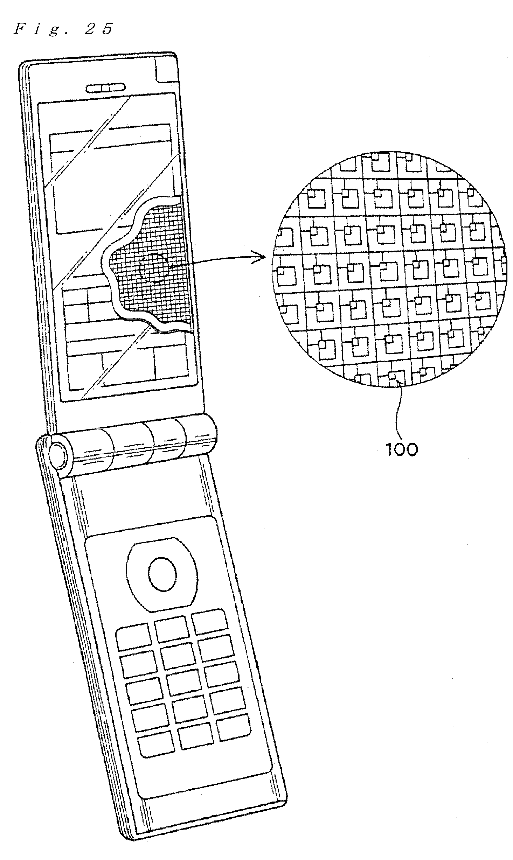

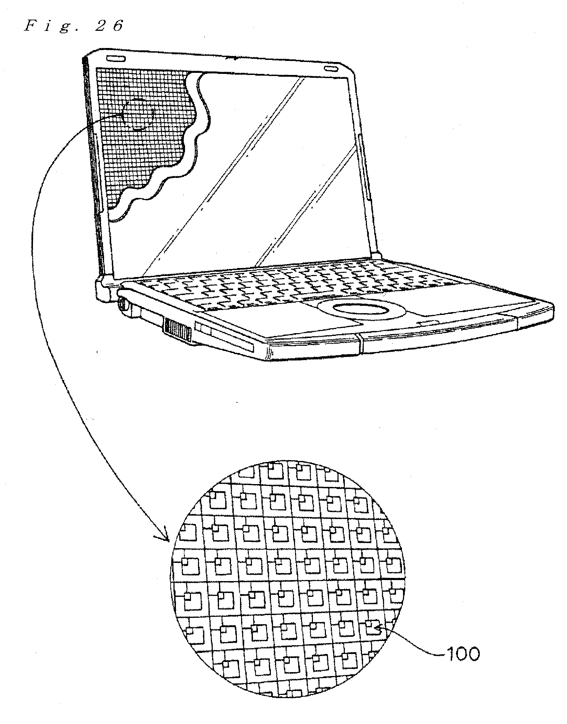

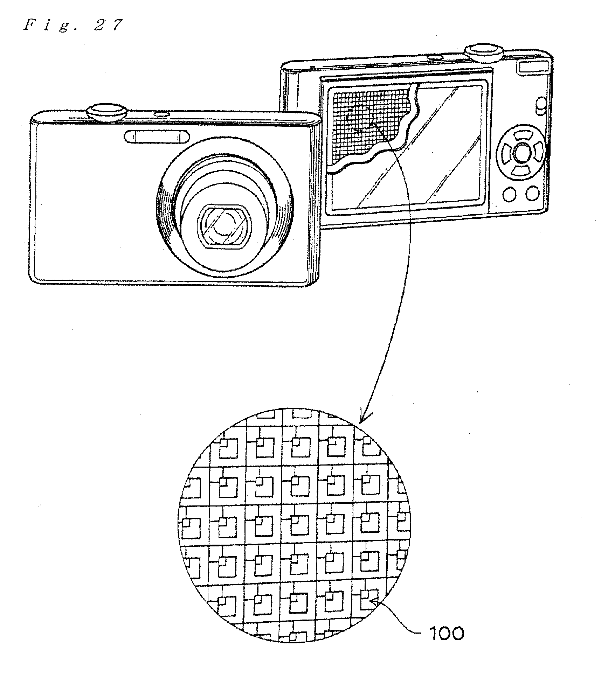

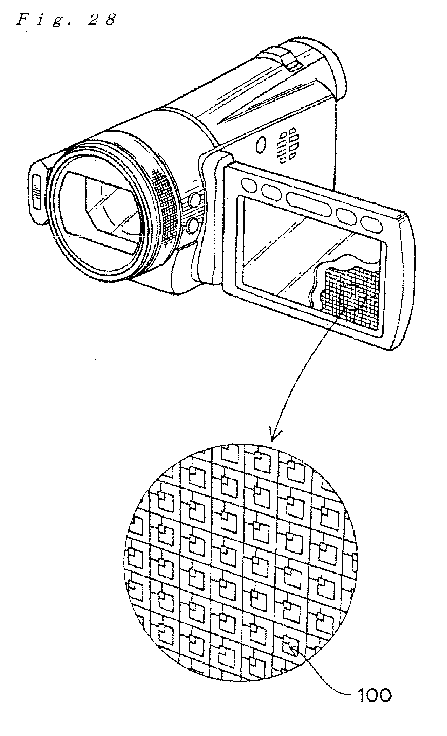

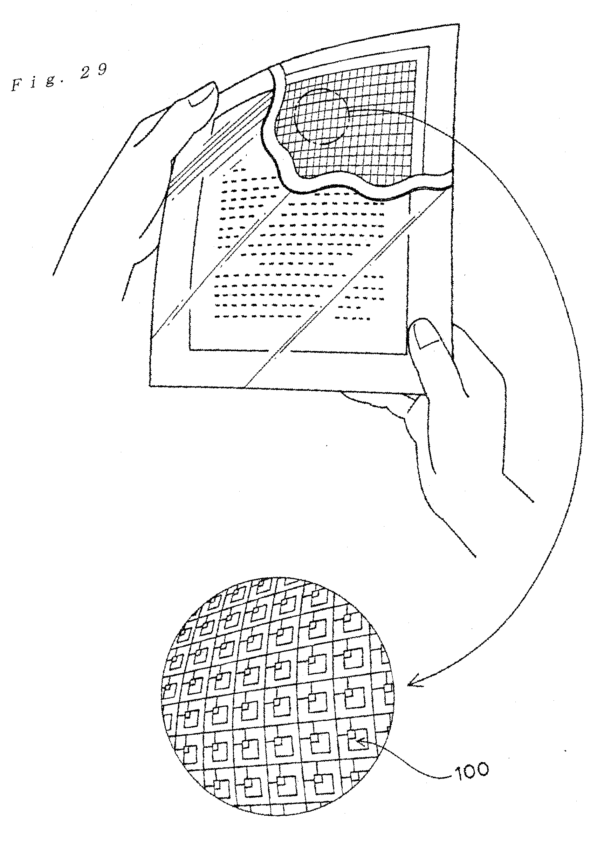

The manufacturing method of the flexible semiconductor device of the present invention is excellent in the productivity of a flexible semiconductor device. The resulting flexible semiconductor device can also be used for various image display parts, and also can be used for an electronic paper, a digital paper and so forth. For example, the flexible semiconductor device can be used for a television picture indicator as shown in Fig. 24, the image display part of a cellular phone as shown in Fig. 25, the image display part of a mobile personal computer or a notebook computer as shown in Fig. 26, the image display part of a digital still camera and a camcorder as shown in Figs. 27 and 28, the image display part of an electronic paper as shown in Fig. 29 and so forth. The flexible semiconductor device obtained by the manufacturing method of the present invention can also be adapted for the various uses (for example, RF-ID, a memory, MPU, a solar battery, a sensor and so forth) which application is now considered to be adapted by the printing electronics.

### CROSS REFERENCE TO RELATED PATENT APPLICATION

The present application claims the right of priorities of Japan patent application No. 2010-112317 (filing date: May 14, 2010, title of the invention: FLEXIBLE SEMICONDUCTOR DEVICE AND METHOD FOR MANUFACTURING THE SAME) and Japan patent application No. 2010-112319 (filing date: May 14, 2010, title of the invention: FLEXIBLE SEMICONDUCTOR DEVICE AND METHOD FOR MANUFACTURING THE SAME), the whole contents of which are incorporated herein by reference.

### EXPLANATION OF REFERENCE NUMERALS

- 10: Insulating layer
- 10g: Gate insulating film
- 11: Electroconductive paste
- 12: Gate electrode
- 13: End face of gate electrode
- 20: Semiconductor layer
- 22: Channel area
- 30s: Source electrode
- 30d: Drain electrode
- 31s: End face of source electrode
- 31d: End face of drain electrode
- 50: Clearance portion (gap portion)
- 60: Resin film
- 62: Irradiation light
- 63: Irradiation light
- 65: Protruding portion (interfitting portion)
- 70: Metal foil
- 72: Supporting substrate
- 73: Supporting substrate
- 74: Resin film
- 80: Display area
- 82: Via
- 84: Wiring
- 85: Capacitor
- 90: Driving circuit
- 92: Data line
- 94: Selection line
- 100: Flexible semiconductor device
- 110: Film-laminated body (body of lamination structure)
- 150: Pixel electrode (picture electrode)
- 160: Pixel regulating part
- 160': Precursor layer for pixel regulating part
- 165: Photomask used for formation of pixel regulating part
- 170: Light emitting layer
- 180: Transparent electrode layer
- 190: Color filter
- 200: Body of lamination structure
- 210: Roller
- 212: Auxiliary roller
- 215: Arrow
- 220: Roller
- 230: Roller
- 300: Image display device
- 300': Image display device

## Claims

1. A flexible semiconductor device comprising :
a gate electrode;
an insulating layer disposed on the gate electrode, the insulating layer having a portion serving as a gate insulating film; and
a source electrode and a drain electrode provided on the insulating layer, the source and drain electrodes being formed of a metal foil,
wherein there is provided a clearance portion between the source electrode and the drain electrode, and thereby the source and drain electrodes between which the clearance portion intervenes are a bank member;
a semiconductor layer is provided in the clearance portion; and
a resin film layer is provided over the insulating layer such that the semiconductor layer, the source electrode and the drain electrode are covered with the resin film layer, and the resin film layer has a protruding portion which is interfitted with the clearance portion.

2. The flexible semiconductor device according to claim 1, wherein opposed end faces of the source and drain electrodes, between which the clearance portion intervenes, are inclined.

3. The flexible semiconductor device according to claim 1, wherein the protruding portion of the resin film layer and the clearance portion located between the source and drain electrodes are in complementary form with respect to each other.

4. The flexible semiconductor device according to claim 1, wherein the semiconductor layer comprises silicon.

5. The flexible semiconductor device according to claim 1, wherein the semiconductor layer comprises an oxide semiconductor.

6. The flexible semiconductor device according to claim 5, wherein the oxide semiconductor is ZnO or InGaZnO semiconductor.

7. The flexible semiconductor device according to claim 1, wherein the gate insulating film is made of an inorganic material.

8. The flexible semiconductor device according to claim 1, wherein the metal foil comprises a valve metal; and
the gate insulating film is an anodically-oxidized film of the valve metal.

9. An image display device using the flexible semiconductor device according to claim 1, the image display device comprising:
the flexible semiconductor device; and
an image display unit composed of a plurality of pixels, the unit being provided over the flexible semiconductor device,
wherein the clearance portion is provided between the source and drain electrodes of the flexible semiconductor device, and thereby the source and drain electrodes between which the clearance portion intervenes are the bank member;
the semiconductor layer of the flexible semiconductor device is provided in the clearance portion; and
the resin film layer of the flexible semiconductor device is provided with the protruding portion which is interfitted with the clearance portion.

10. A method for manufacturing a flexible semiconductor device, the method comprising the steps of:
(A) providing a metal foil;
(B) forming an insulating layer on the metal foil, the insulating layer having a portion serving as a gate insulating film;
(C) forming a supporting substrate on the insulating layer;
(D) etching away a part of the metal foil to form a source electrode and a drain electrode therefrom;
(E) forming a semiconductor layer in a clearance portion located between the source electrode and the drain electrode by making use of the source and drain electrodes as a bank member; and
(F) forming a resin film layer over the insulating layer such that the resin film layer covers the semiconductor layer, the source electrode and the drain electrode,
wherein, in the step (F), a part of the resin film layer interfits with the clearance portion located between the source and drain electrodes.

11. The method according to claim 10, wherein the metal foil is subjected to a photolithography process and a wet etching process in the step (D), and thereby forming inclined opposed end faces of the source and drain electrodes, between which the clearance portion intervenes.

12. The method according to claim 10, wherein the step (F) is performed by a roll-to-roll process.

13. The method according to claim 10, wherein, after a removal of the supporting substrate, a gate electrode is formed on the surface of a portion of the insulating layer, the portion corresponding to the gate insulating film.

14. The method according to claim 10, wherein a ceramic substrate or a metal substrate is used as the supporting substrate.

15. The method according to claim 10, wherein, in the step (B), the gate insulating film is formed by a sol-gel process.

16. The method according to claim 14, wherein, after the step (B), the gate insulating film is subjected to a heat treatment.

17. The method according to claim 14, wherein, after the step (E), the semiconductor layer is subjected to a heat treatment.

18. The method according to claim 10, wherein, a metal substrate is used as the supporting substrate; and
after the step (F), a gate electrode is formed by subjecting the metal substrate to a pattering process.
